(19)

**Europäisches Patentamt**
**European Patent Office**
**Office européen des brevets**

(11) **EP 2 221 874 A1**

(12) **EUROPEAN PATENT APPLICATION**

(43) Date of publication:
**25.08.2010 Bulletin 2010/34**

(51) Int Cl.:
*H01L 29/12* (2006.01)   *H01L 29/16* (2006.01)
*H01L 29/76* (2006.01)   *H01L 29/06* (2006.01)
*H01L 29/78* (2006.01)

(21) Application number: **09153539.3**

(22) Date of filing: **24.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **S.a.r.l. FIRMUS**
**98000 Monaco (MC)**

(72) Inventor: **Shpenkov, Georgi**
**43-300 Bielsko-Biala (PL)**

(74) Representative: **Berger, Helmut**
**Cabinet Weinstein**
**56 A, rue du Faubourg Saint-Honoré**
**75008 Paris (FR)**

(54) **Method for manufacturing nano electronic devices made from 2D carbon crystals like graphene and devices obtained with this method**

(57) The invention proposes a method for manufacturing nano electronic devices made from at least one planar carbon based molecule,
comprising the steps of:
- identifying in an elementary indivisible nanoformation (ECNF) of the planar carbon based molecule, relations between predetermined axis of orientation (AA, BB) with respect to a reference orientation and physical properties such as electric current conduction properties,
- realising devices having predetermined of said properties by positioning the ECNFs (2) therein according to the orientations corresponding to said properties, such as a Field Effect type device having a source portion 51, a drain portion 53 and between them a gate portion 52.

The invention also proposes nano electronic devices obtained by this method.

The invention finds application at least in the field of nanoelectronics.

FIG. 17 A

**Description**

The invention relates to a method for manufacturing nano electronic devices made from at least one planar carbon based molecule, and nano electronic devices obtained with this method.

There is an increasing interest for such devices particularly for device made on the basis of graphene.

Graphene is a planar carbon based molecule, and a one-atom thickness crystal that exhibits interesting and useful electric properties.

Its properties enable the increasing of the density of electronic components in electronic devices and reducing the power consumption per component.

There is known from the US patent 2004/0253820 a method for manufacturing nano electronic devices comprising graphene by the growing of a thin film graphitic layer on a preselected crystal face and by the patterning of this film graphitic layer thanks to lithography, in order to obtain a Field Effect Transistor composed of graphene.

However the technology of graphene material is until now only used in laboratory conditions and yet not valid for an industrial application.

Indeed, graphene material has been found to have an anisotropy of its physical properties which cannot be explained from the actually admitted isotropic carbon atomic concept with a nucleus in the center and electrons "clouds" (orbitals) around it.

It is impossible to manufacture graphene nanoelectronic devices having predictable and reproductable properties.

Thus, when a plurality of graphene devices is manufactured even with identical parameters of manufacturing, these devices will show electrical properties which are different from one another because it is impossible to control the properties of such device.

The object of the invention is to solve this problem.

For this purpose, the invention proposes a method for manufacturing nano electronic devices made from at least one planar carbon based molecule, comprising the steps of:

- identifying in an Elementary indivisible Carbon NanoFormation (ECNF) of the planar carbon based molecule, relations between predetermined axis of orientation with respect to a reference orientation and physical properties such as electric current conduction properties,
- realising devices having predetermined ones of said properties by positioning the ECNF therein according to the orientations corresponding to said properties.

According to another aspect of the invention, said ECNF is identified on an image as an entity of six nodes with three nodes on each side of a first symmetric axis ZZ', arranged in a V like configuration that is symmetrically about a second axis YY' perpendicular to the first axis ZZ', the two V like configurations of three nodes 6, 7 pointing to each other.

According to another aspect of the invention, in the orientation of the first axis ZZ' the ECNF is recognized as to have superconducting properties.

According to another aspect of the invention, in the orientation of the second axis YY' the ECNF is recognized as to have semiconducting properties.

According to another aspect of the invention, for obtaining a device including a portion having superconducting properties between two different polarising potentials, at least one ECNF of this portion is positioned with its superconducting channel parallel to the direction defined by the two different polarising potentials.

According to another aspect of the invention, for obtaining a device including a portion having semiconducting properties between two different polarising potentials at least one ECNF of this portion is positioned with one of its orientation different from superconducting orientation (AA) between the two different polarising potentials.

According to another aspect of the invention, the orientation of superconductivity is defined as a direction parallel to "zigzag edge" of a sheet of carbon atoms crystal.

According to another aspect of the invention, the semiconductivity orientation is defined as being parallel to an "armchair edge", a "C like edge" or a "hook like edge" of a carbon based sheet crystal.

The invention also proposes a nano electronic device made from at least one planar carbon based molecule, manufactured in accordance to the above method, wherein planar carbon atom based sheet portions are arranged in orientation with respect to one another corresponding to predetermined polarisation.

According to another aspect of the invention, in a field effect kind device, a portion electrically polarised in a semiconducting orientation is arranged between two portions electrically polarized in a superconducting orientation.

According to another aspect of the invention, the said at least planar carbon based molecule in which the nano electronic device is made is chosen among graphene, naphtene, coronen, benzene and quinacridone.

According to yet another aspect of the invention, the said portion electrically polarised in a semiconducting orientation and arranged between two portions electrically polarized in a superconducting orientation, is a planar carbon based molecule controllable by a magnetic field (B) so as to act as a trap for electron, such as a benzene or a coronene molecule.

According to another aspect of the invention, the nano electronic device constitutes a quantum dot and comprises three portions electrically polarized in a superconducting orientation, the two end portions forming respectivelly a drain and a source portions, connectable to a drain and a source electrodes, the intermediate portion being connected to the two end portions via two planar carbon based molecule controllable by a magnetic field (B) so as to act as a trap for electron, such as a benzene or a coronene molecule, the intermediate portion defining with each molecule controllable by a magnetic field, a tunnel junction.

Specific embodiments of the invention will now be described in reference to the following drawings:

Figure 1 is a schematic view of a microscope high resolution electronic transmission image of a sheet of graphene.

Figure 2 shows a disposition of the main axis of symmetry Z in an elementary carbon nanoformation.

Figure 3A shows principal internodal bonds in ECNF. Figure 3B is the conditional designation of ECNF shown in figure 3A.

Figure 4A shows a superconducting channel formed of empty spatial nodes located along the Z axis in ECNF.

Figure 4B is a schematic view of ECNF in two projections with its spherical space shell.

Figure 4C is one more conditional designation of ECNF shown in figure 4A.

Figure 4D is a schematic view of ECNF in three projections (from the left side of figure 4A, on the same side of the figure 4A and from above of the figure 4A) with kinetic (empty) spatial nodes.

Figures 5A-C show the principal directions of self-binding (assembling) of manifold systems from ECNFs approaching one another in accordance with the next embodiment of the invention.

Figure 6A-C are the three schematic views of a fragment of a graphene sheet demonstrating one of the guided connections of ECNFs resulted in an appearance of strictly directed superconducting (ballistic) channels in the plane structure of graphene; zigzag and armchair edges of graphene sheets are the typical crystal's faces of graphene.

Figures 7A,B are other schematic views of a graphene sheet, shown in figure 6.

Figure 8 is yet another schematic view of a graphene sheet, shown in figure 6 demonstrating three different types of crystal face's edges.

Figure 9A is another schematic view of a graphene sheet, shown in figure 8 demonstrating the total four possible types of crystal face's edges.

Figure 9B is a schematic view of a microscope image of the sheet of graphene of the figure 9A, showing the internodal boundary bonds four different edges of this sheet.

Figures 10A-D shows a formation of typical metastable pentagon-heptagon (5-7) defects (two pairs of five- and seven-membered rings of carbon nodes) spontaneously appeared in a fixed but elastic hexagonal graphene lattice and remained stable for up to several seconds.

Figure 11 is a formation of one more typical metastable defect, similar to shown in figure 10, but with four pairs of five- and seven-membered rings of carbon nodes.

Figure 12 shows the crystallographic structure of a graphene nanoribbon (GNR) for field-effect devices, carved in such a way to have a semiconductor path between a pair of displaced with respect to each other superconducting channels connected, respectively, with a source and drain. In the interests of simplicity and clarity, only two semiconductor paths of GNR are depicted.

Figure 13 shows the crystallographic structure of GNR for field-effect devices carved in a similar way, like shown in figure 12, but with one leakage (superconducting) channel, which makes it impossible to have an intermediate path with pure semiconductor properties between two parts of GNR with superconducting channels connected with a source and drain.

Figure 14 shows the crystallographic structure of GNR for field-effect devices, like shown in figure 12, but with a semiconductor path carved in a direction B-B as indicated in figure 9.

Figure 15 is a schematic view of one-channel paths of GNR built from ECNFs, patterned from GNR depicted in figure 13, shown in the interests of simplicity and clarity.

Figure 16 is a schematic view, like shown in figure 15, but with a semiconducting path along the direction B-B as it is shown in the figure 14.

Figure 17 is a schematic view of a field-effect device in accordance with one embodiment of the invention. Figure 17A is a crossed sectional view of the field-effect device of the figure 17.

Figures 18A,B are schematic diagrams of two exemplary configurations of field-effect devices made according to the invention, taking into account ECNFs orientation.

Figures 19A,B are schematic views of a field-effect device in accordance with another embodiment of the invention.

Figure 19C is a schematic view illustrating different steps of the process of manufacture of the field effect device of the figure 19A.

Figures 20A,B are schematic views of a field-effect device in accordance with one more embodiment of the invention.

Figures 21A,B are schematic views of a field-effect device in accordance with yet another embodiment of the invention.

Figures 22A, B are schematic views of a field-effect device in accordance with yet more embodiment of the invention.

Figure 23 is a schematic view of a field-effect device in accordance with next embodiment of the invention.

Figures 24A,B are schematic views of a naphtene molecule (24B) presented as consistent of a benzene molecule stacked with 2 bonded ECNFs (24A). Figures 24C,D are schematic views of the crystal structure of a coronen molecule (24D) presented as consistent of 2 stacked naphtene molecules bridged by 2 ECNFs (24C).

Figures 24E,F are schematic views of a triad of major parts of FEDs related with source, gate, and drain, where the naphtene (24E) and coronen (24F) molecules are used in the field gate region.

Figures 25A,B are schematic views of a triad of basic elements of FEDs, like shown in figures 24E,F but with another orientation of the naphtene (25A) and coronen (25B) molecules, respectively,

Figures 26A,B are the two schematic views, additional to that shown in figure 24F, with a more detailed description related to the structure of the FED based on the same triad, in the interests of more clarity.

Figure 27 is a schematic view of the carbon basis of a quinacridone molecule represented with its constituent ECNFs.

Figures 28A,B are schematic views of exemplary FEDs comprising coronen molecules used as source and drain.

Figures 29A,B are, respectively, schematic views of 2 coronen molecules (29A), and a 2-D crystal structure (29B) obtained from the junction of 6 coronen molecules assembled one another in the way indicated in figure 29A.

Figure 29C is a drawing of disposition of crystal nodes in the two-dimensional crystal structure shown in figure 29B visible by electron microscope and fixed in the corresponding micrographs.

Figure 29D is a drawing of both schematic view of the structure (invisible) shown in figure 29B, and the disposition of crystal nodes (visible) shown in figure 29C.

Figure 30 is a schematic view of FED on the basis of the 2-dimensional coronen structure of 6 coronen molecules (presented in figure 29B) and the 2 GNRs (A).

Figures 31 is a principal scheme of a nanoelectronic device of 2 paralleled gates made entirely on the basis of a coronen crystal, which structure is depicted in figures 29B, C, D and 30.

Figure 32 is a schematic view of a fragment of a coronen crystal network formed by binding coronen molecules in the way indicated in figures 29A,B.

Figure 33 is a schematic view of the 3 stages of one of the imprinting methods.

Figures 34A,B are, respectively, schematic views of 2 coronen molecules and a 2-D crystal structure resulted in junction of 7 coronen molecules in the way indicated in figure 34A.

Figure 35 is a schematic view of a fragment of a coronen crystal network formed by binding coronen molecules as indicated in figures 34A,B.

Figure 36 is a schematic view of an intermediate state of overlapping of two individual ECNFs for the formation of a ECNF and before the complete mutual penetration of the two single ECNFs.

The present invention is based on the discovery of the inventor of a new concept on the structure of carbon atoms that allows explaining the currently unexplainable anisotropy of the electrical properties of graphene.

Indeed, as already set forth above, the actual knowledge of graphene cannot explain the observed anisotropic electrical properties of graphene since the currently admitted concept of atoms is of the electronic orbitals and therefore isotropic type.

Furthermore, still according to the current knowledge, graphene is considered to have a symmetrical honeycomb hexagonal structure (crystallographic space group is $P6_3/mmc$ ( $D_{6h}^4$ )) and should have symmetrical physical properties which is in opposition with the anisotropic properties observed.

The concept used by the inventor led him to the discovery of an "*Elementary Carbon NanoFormation*" which is anisotropic in structure.

It is this anisotropy of the structure which explains the anisotropy of the physical properties and is thus essential for the understanding of the physical properties of graphene.

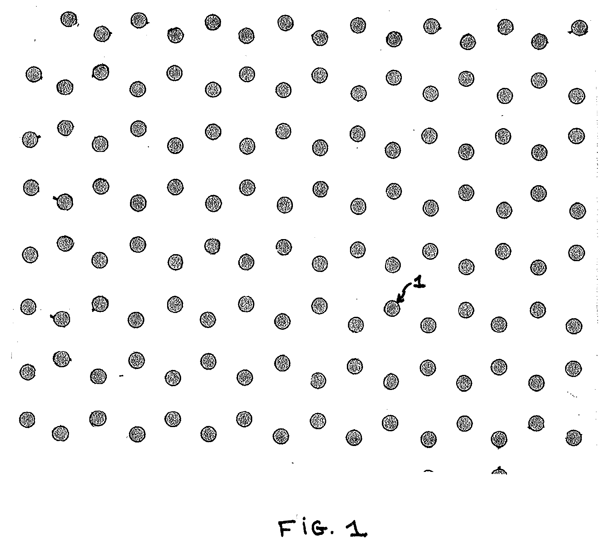

This new concept leads to an interpretation of microscope images of graphene, as the schematic one illustrated in the figure 1, which is fundamentally different from the actually generally accepted one and allows to predict properties of electric current conductivity of the graphene in predetermined directions, what the commonly admitted interpretation cannot do.

The very base of the concept discovered by the inventor, the Elementary Carbon NanoFormation, will be described below only for the needs of the understanding and working of the invention, but is described in a detailed manner in the document "*An Elucidation of the nature of the periodic law - The intra atomic structure of carbon and oxygen*", the author of which is the inventor.

For reasons of simplification in the following text the term "ECNF" will be used for the Elementary Carbon NanoFormation.

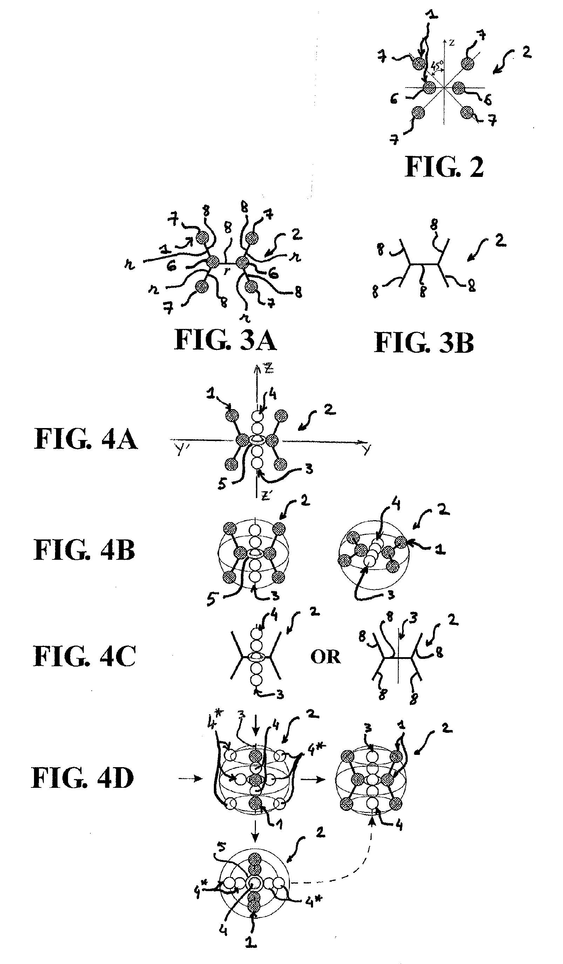

As represented in figures 2 to 4, an ECNF 2, is an indivisible integer nano-object comprising six nodes 1 represented by a shaded circle each containing two nucleons, and five axial, polar (potential-kinetic) nodes 4, each represented by a white circle and which are empty.

The six nodes 1 are arranged so that three nodes 1 are disposed on each side of a first symmetric axis ZZ', in a V like configuration that is symmetrically arranged about a second axis YY' perpendicular to the first axis ZZ', the two V like configuration pointing to one another.

As shown in the figure 3A, the central node 6 of each V like configuration, called thereafter "internal node" is connected to the two end or external nodes 7 by internodal bonds 8 represented by a thick line in this figure.

The two internal nodes 6 are connected to one another by an internodal bond 8.

The lengths of the internodal bonds 8 between the nodes of the ECNF are identical and are defined by roots of Bessel functions that are solutions of the wave equation for an equilibrium state of ECNF.

For reasons of simplification, the ECNF 2 is represented in some different manners:

- in the figure 3B, only the bonds 8 are shown without the nodes and are represented by thick lines,
- in figures 4A-D, a central spatial channel 3 is depicted in the axis of ZZ' which includes the five empty nodes 4 and is represented by a fine line 3,
- furthermore, the figure 4D is a schematic view of ECNF in 3 projections (on the left side of figure 4A, on the same side of figure 4A, and from above of figure 4A) which takes into account six kinetic polar-azimuthal spatial (empty) nodes 4*. The six empty nodes 4* are positioned in the same configuration as the nodes 1 but are arranged in a perpendicular plane.

The figures 4A, 4B and 4C show additionally a toroidal spatial formation 5 which is located around the central empty node 4.

On an image made by an High Resolution Transmission Electron Microscope (HRTEM) of a sheet of graphene, of the kind of the figure 1, the nodes 1 of carbon atoms are visible as bright points, but appear in the figure 1 as shaded points, whereas the internodal bonds are invisible in such image.

The empty axial nodes 4 are also invisible but follow from a strict solution of the wave equation as is shown in the above-cited reference "*An elucidation of the nature of the periodic law*".

These axial empty nodes 4 form a central spatial channel 3 allowing the ballistic motion of charges through ECNF, i.e. motion without their scattering, dispersion, and resistance, along the first axis of symmetry ZZ'. Accordingly, this channel constitutes a superconducting channel 3. In other directions, the ECNF has conductivity, which is characteristic for semiconductors. Around the central empty node 4, there is a toroidal spatial formation 5.

The forced filling in accelerators by neutrons of the superconducting channel 3 (cf. empty nodes 4) in the 6-C-12-carbon isotope yields short-lived carbon isotopes that directly confirm an existence and the role of nodes 4 in the channel.

Accordingly, the above described structure of ECNF shown in figure 4A as being indivisible under influence of customary in value external forces, excluding the nuclear level forces, is found to be proved experimentally and mathematically. The internodal binding energies in ECNF are of the order of nuclear.

As results from the foregoing, and as illustrated in the figures 4B and 4D, the ECNF 2 as a space object has a spherical space structure determined by the complex field configuration of internodal electromagnetic bonds.

The ECNF 2 with a spherical space shell is schematically shown in two projections in figure 4B.

For more precise description it should be noted that the nodes 1 depicted in figures 1-4A,B by shaded circles, are potential (polar-azimuthal) i.e. they can be considered as to constitute in a representation of standing waves non moving points. They are places of concentrated matter.

The axial empty nodes 4 are potential and kinetic nodes at the same time, rest and motion simultaneously. They are called therefore potential-kinetic nodes. They are the places of metastable states for matter (particles) which may appear there for some reasons.

The empty nodes 4* are kinetic polar-azimuthal nodes and they can be considered as to be the points of maximum motion. They cannot be places for concentrated matter.

It is to be noted that in gaseous carbon based structures carbon atom is present in the form of a single ECNF.

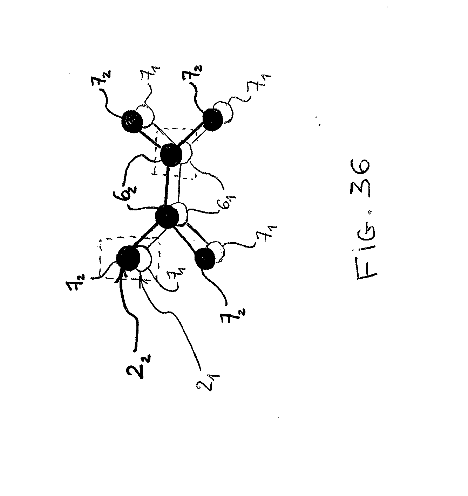

But in solid carbon based structures, such as graphene sheet, carbon is present in the form of a molecule $C_2$ i.e. a molecule formed by superposition and mutual penetration of two individual ECNFs $2_1$, $2_2$. An intermediate step of the superposition and mutual penetration of two ECNFs $2_1$, $2_2$ resulting in the formation of the molecule $C_2$ is illustrated schematically in the figure 36.

Accordingly, in solid carbon based state structures, an indivisible unit of carbon is constituted by a double ECNF.

Such a double ECNF is formed by two superposed and mutually penetrated individual ECNFs, defining the same volume as a single ECNF and comprises in each of its external 7 and internal nodes 6, four nucleus, two nucleus coming from the first ECNF $2_1$ and the two others from the second ECNF $2_2$.

Accordingly, a double ECNF has the same shape as the one of an individual ECNF and has a thickness substantially equal to the thickness of a single ECNF.

Therefore, apart from the number of nucleus in each nodes which are different (2 for a single and 4 for the double ECNF), the features of single and double ECNF are the same (same structures, same thickness, same volume as explain above).

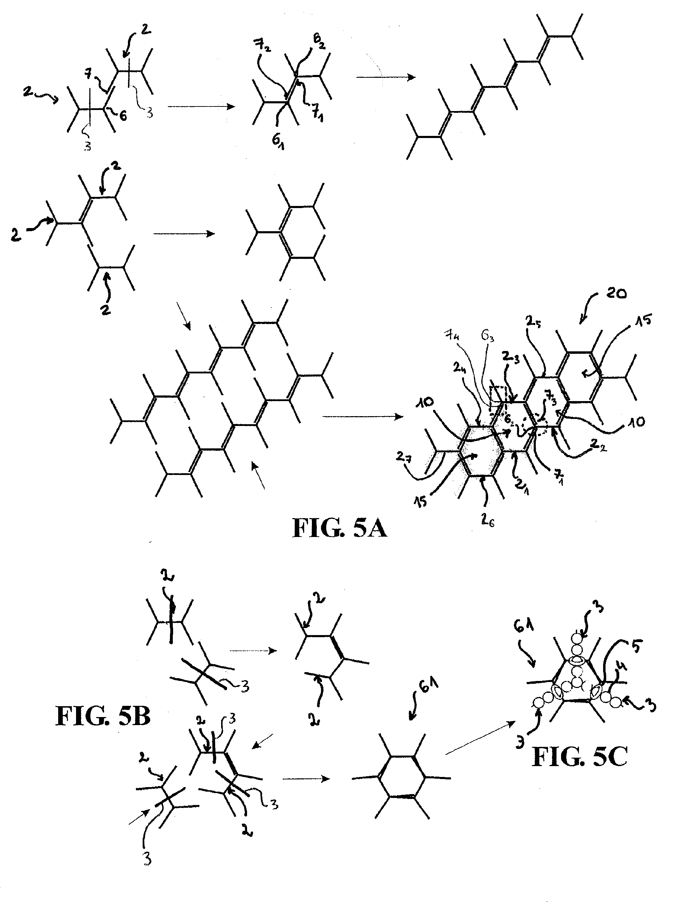

It is to be noted that the following description made relatively to the figures 5A to 35 concerns solid carbon based structures (graphene, benzene, naphtene, quinacridone, coronen molecules...) and involves therefore only double ECNFs.

However, for the sake of clarity, only the word "ECNF" and the reference "2" will be used in the following description to designate a "double ECNF".

The way of establishing the connection between ECNFs is illustrated in detail by the different steps of connection in the figure 5A.

According to this figure 5A, two ECNFs approach one another under influence of mutual electromagnetic forces between the internal node $6_1$ of a first ECNF and the external node $7_2$ of the second ECNF, and between the internal node $6_2$ of a second ECNF and the external node $7_1$ of the first ECNF and providing that:

- the first ECNF approaches the second ECNF with the described natural (thermodynamically equilibrium) relative orientation, which is along the bonds between internal node 6 and external node 7 of every ECNFs, with the result that their superconducting channels 3 are arranged parallel to one another,
- external disturbances of the different nature (e.g., by heating, laser excitation, electronic beam manipulation, etc.) are controlled so long as will not be achieved the overlapping of the nodes.

This process of binding two ECNFs 2 to one another results in an extreme minimum value of the total energy of obtained joined structure.

As results from the figure 5A, a graphene sheet is formed by a plurality of ECNFs which are connected to one another with three multiple overlapping of the nodes of adjacent ECNFs.

As seen on the molecule 20 obtained, a crystal lattice of hexagonal rings, typical of graphene is formed.

This molecule 20 constitutes a 4-hexagonal rings lattice with two internal hexagonal rings 10 and two end hexagonal rings 15.

To determine the number of ECNFs which compose a hexagonal ring, the number of different ECNFs that have at least one node disposed at a corner (or vertex) of the hexagonal ring should be identified as indicated below:

In the first internal hexagonal ring 10 of the molecule 20 of the figure 5A:

- two ECNFs $2_2$, $2_4$ have three nodes (one internal and two external) placed respectively at three corners of the hexagonal ring,
- two ECNFs $2_1$, $2_3$ have four nodes (two internal and two external) disposed respectively at four corners of the hexagonal ring,
- and two ECNFs $2_5$, $2_6$ have one node (external node) placed at one corner of the hexagonal ring.

Therefore, in this first internal hexagonal ring 10, six ECNFs $2_1$, $2_2$, $2_3$, $2_4$, $2_5$, $2_6$ have at least one node disposed at a corner of the hexagonal ring, so that the number of ECNFs composing the first internal hexagonal ring 10 is of six.

And four corners of this hexagonal ring 10, as the one indicated by a dotted circle, are composed of three nodes i.e. one internal $6_2$ and two externals $7_1$, $7_3$ coming from respectively three different ECNFs $2_2$, $2_1$, $2_3$, overlapping one another. The two other corners, as the one indicated by a dotted rectangle, are composed of two nodes i.e. one internal $6_3$ and one external $7_4$ of two different ECNFs $2_3$, $2_4$.

It is the same for the second internal hexagonal ring 10.

But it is different for the two end hexagonal rings 15 of this molecule 20, which are each formed by five ECNFs (for example for the left end hexagonal ring 15, the five ECNFs $2_1$, $2_4$, $2_3$, $2_7$, $2_6$) and have three corners made from three overlapping nodes (one internal and two external nodes), and three corners made from two overlapping nodes (one internal and one external nodes).

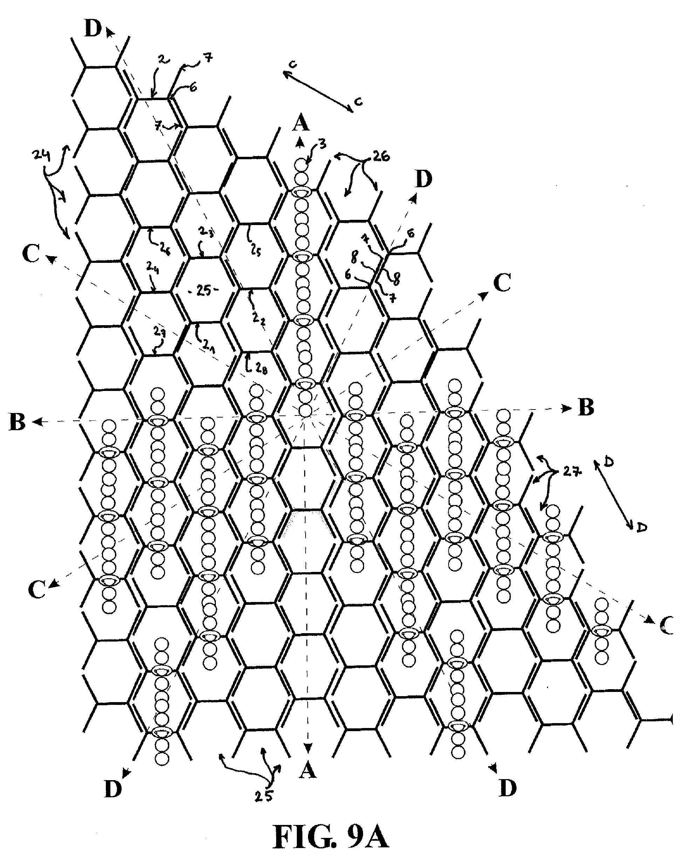

Also, for a hexagonal ring 25 of a wider graphene sheet as illustrated in the figure 9A, and disposed far enough from the edges of this sheet, the number of ECNFs constituting a hexagonal ring 25 is different from the one of hexagonal rings 10, 15 of the molecule 20 of the figure 5A, since in this case eight ECNFs $2_1$, $2_2$, $2_3$, $2_4$, $2_5$, $2_6$, $2_7$, $2_8$ form this hexagonal ring 25, and the number of nodes at the corners of this ring 25 is identical for all corners and equals to three (one internal and two external nodes).

Therefore, the number of ECNFs constituting a hexagonal ring in a crystal lattice and the number of nodes forming the corners of this hexagonal ring, depend on the position of this ring with respect to the crystal edges.

Accordingly, physical properties (including electric, magnetic and mechanical) of the narrow nanoribbons of the atomic level width (used in FEDs) will essentially depend on the number of overlapped nodes and multiplicity of their overlapping (0, 2, or 3 multiple) in a honeycomb lattice structure of the ribbon. These properties will depend also on the correlation between the numbers of different in structure (aforementioned) rings themselves in the ribbon.

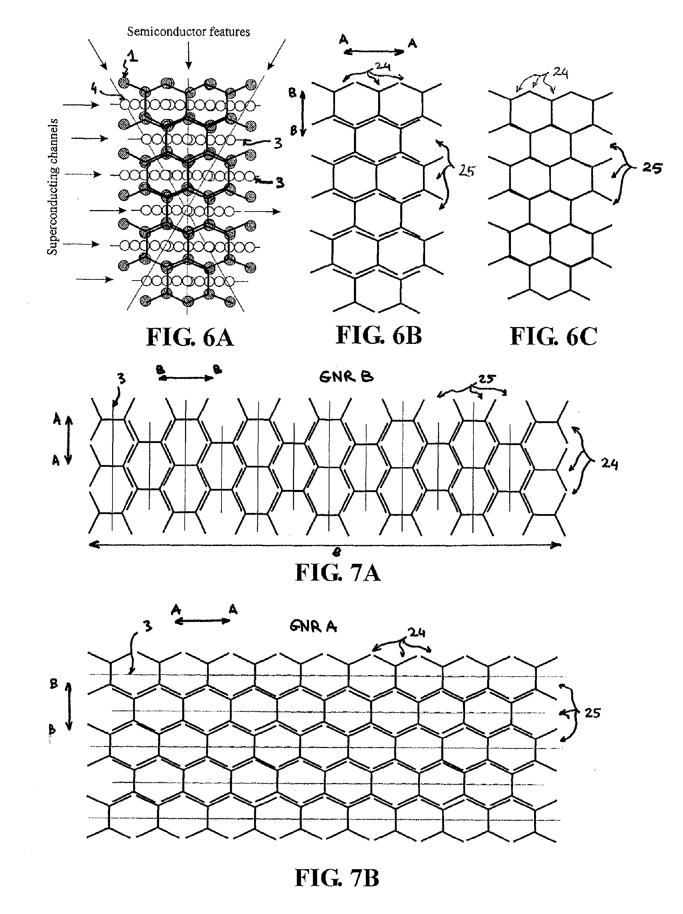

On high resolution microscope image such as the one schematically represented in the figure 1, these three overlapping nodes 6, 7 belonging to three different ECNFs 2 are visible as unique "bright point" illustrated by a shaded circle on the enclosed figures. The three-multiple overlapping of the nodes belonging to three different (double) ECNFs in a graphene lattice is shown in figures 6A to 6C.

This is fundamentally different from the currently admitted structure according to which one bright point on a microscope image is believed to relate to an individual carbon atom, contrary to the invention according to which an individual carbon atom is formed by an ECNF and thus by six nodes connected between themselves by strong interaction.

Figure 6A indicates the orientation of superconducting channels 3 defining a superconductivity direction AA, and perpendicular thereto, the direction BB of semiconducting properties of graphene. These directions of superconductivity AA and of semiconductivity BB are defined also on the schematic figures 6B and 6C. The direction of semiconductivity BB perpendicular to the superconducting channels 3 is the direction of pure semiconductivity of the sheet of graphene, i.e. with the largest gap and thus minimal conductivity.

It results from the figure 6B that the direction of superconductivity AA is parallel to "zigzag edges" 24 and the direction of semiconductivity BB is parallel to an edge of the graphene perpendicular to the zigzag edge and called "armchair edge" 25.

The zigzag edge and the armchair edge are the outer faces of graphene crystals.

Accordingly, observation of the form of crystal faces edges allows to identify in the crystal lattice the ECNFs and the specific orientation thereof determine the physical properties.

Knowing the relation between the orientation of the physical properties of graphene crystal and the shape of the crystal faces edges, allows to realise graphene device by correspondingly carving graphene sheets.

Figures 7a and 7b show two perfect graphene nanoribbons called hereafter GNR carved in two ways with respect to superconducting channels 3, i.e. in the direction BB perpendicular to the channels and along them in the direction AA, which provide, respectively, pure semiconducting and superconducting properties. Fine lines 3 indicate the axis AA of the superconducting axial channel.

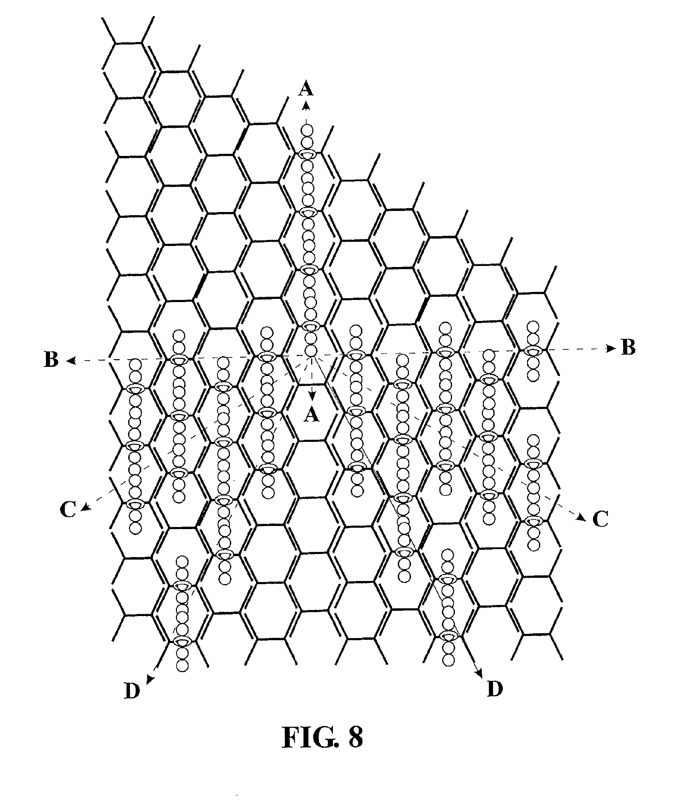

The figure 8 shows two other specific orientations CC and DD of semiconductivity, with a minor gap than the gap of semiconductivity in the direction BB, the orientation DD being parallel to the internodal bonds 8 between an external and an internal node, and the orientation CC being perpendicular to this internodal bond 8.

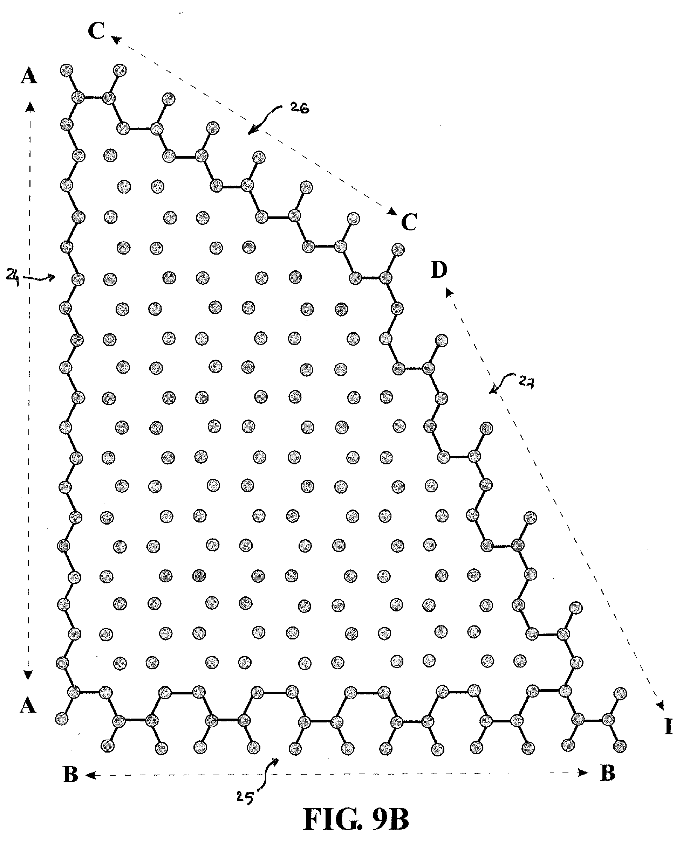

Figures 9A and 9B illustrate the relation between the possible four orientations. The schematic view of a graphene sheet observed by a High Resolution Transmission Electron microscope, shown in figure 9B demonstrates all four possible types of crystal face's edges having relation to four possible types of linear GNRs. It results from the figure 9B that the orientation of semiconductivity CC is parallel to "C like edges" 26 and the orientation of conductivity DD is parallel to "hook like edges" 27.

Nanoribbons having zigzag edges 24, arm chair edges 25, C like edges 26 or hook like edges 27 and the associated physical properties can thus be produced by correspondingly carving a graphene sheet, i.e. from a gigantic 2-D molecule, in the main directions: A-A, B-B, C-C, and D-D, as indicated in figure 9A corresponding to the desired specific property.

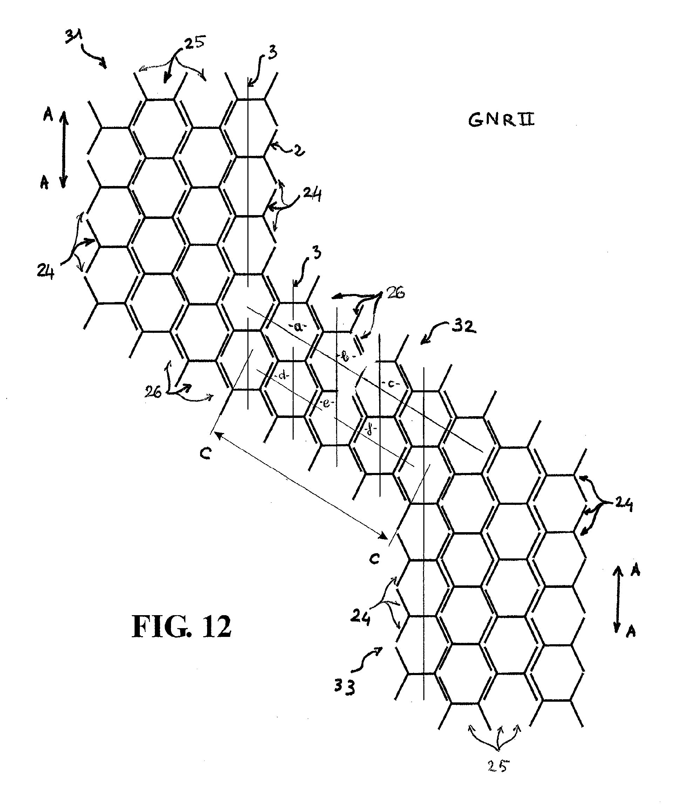

With reference to the figures 12 to 16, some particular crystallographic structure of a graphene nanoribbon (GNR) adapted to be used in a nanoelectronic devices will be described below. As for examples, the devices are of the type of field-effect devices.

The crystallographic structure of a graphene nanoribbon (GNR) for such devices must be patterned with nanometer-precision, a well-defined width and predetermined crystallographic orientation.

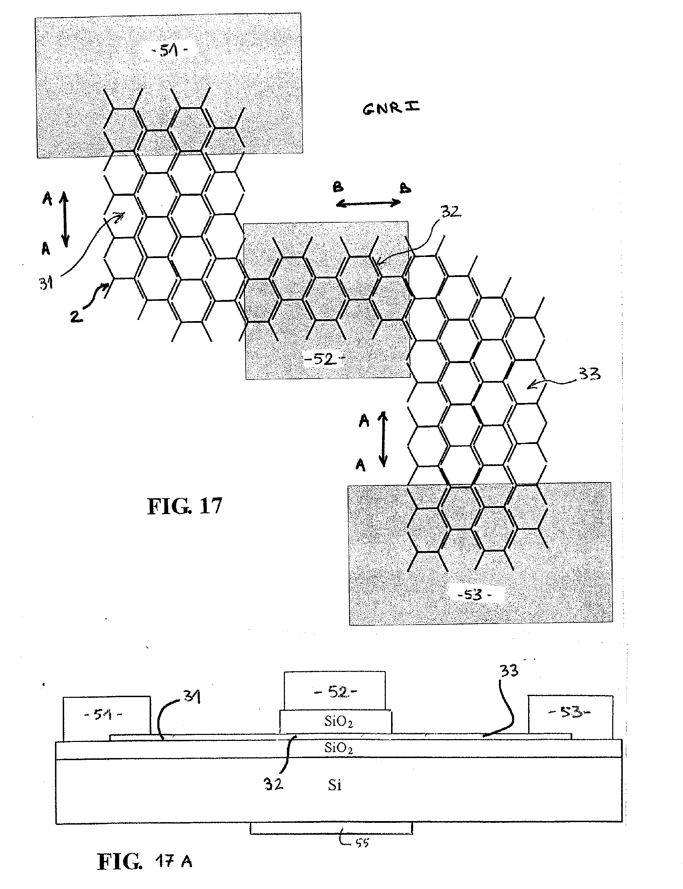

The GNR shown in the figure 12 has a ribbon like lattice portion 32 carved in a way to constitute a semi conducting path, i.e. carved along the CC direction, intended to be connected to a gate, this portion being interposed between a pair of other ribbon like portions 31, 33, carved along the direction AA so as to have a superconducting orientation, each portion being intended to be connected to an electric potential, one constituting the source, the other one the drain of the field-effect transistor (FET) like device (drain and source are not illustrated in this figure 12 but in the figure 17 for another kind of GNR).

For electronic device applications, such ribbons have to be deposited on an insulating substrate. In the interests of simplicity and clarity, in the example shown in figure 12, only six hexagonal rings (a, b, c, d, e, f) each formed from seven ECNFs are depicted for constituting the semiconducting path of GNR.

The width of three GNR parts, and hence, the number of hexagonal rings in them depends on advantages of lithography.

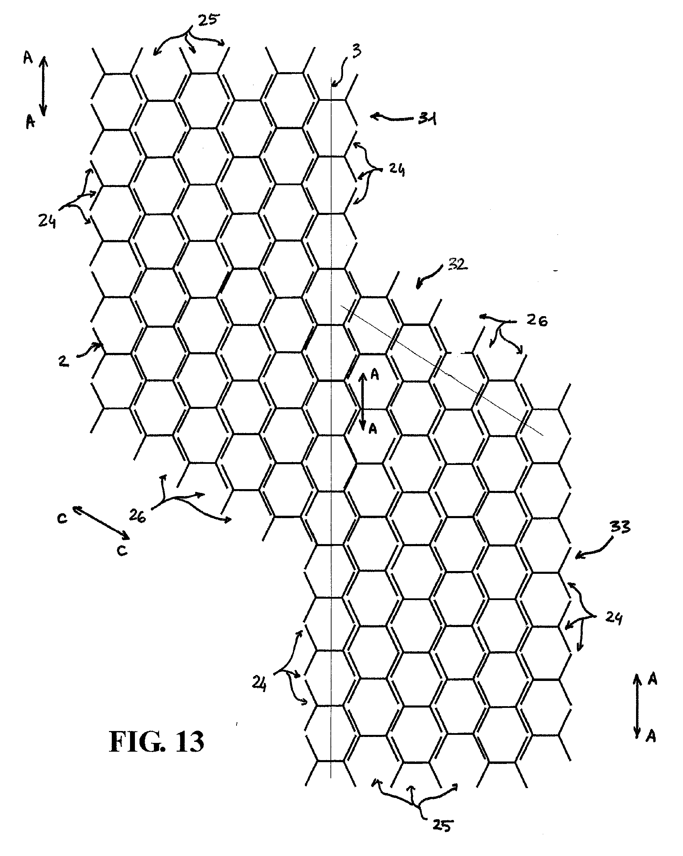

Figure 13, shows a crystallographic structure of GNR for field-effect devices carved in a similar way, as shown in figure 12, which however has a leakage (superconductive) channel 3 extending through the first, second and third portions 31, 32, 33. This channel makes it impossible to have an intermediate path 32 with pure semiconductor properties between two parts of GNR with superconducting channels connected with a source and drain.

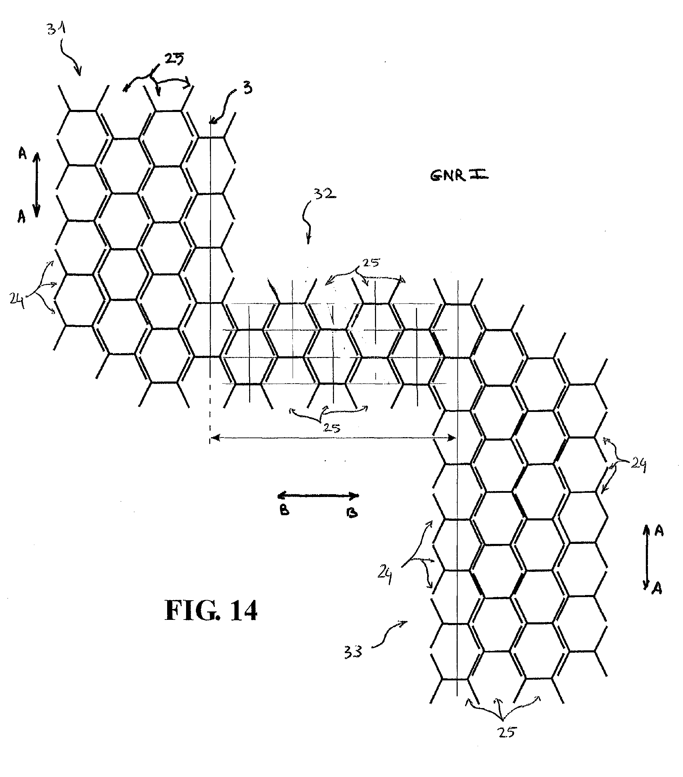

A crystallographic structure of GNR for field-effect devices, like the one shown in figure 12, but with a semiconductor path carved just in a perpendicular direction B-B, as indicated in figure 9, with respect to superconductive channels of the GNR, is shown in figure 14. Such GNRs are more preferable if one needs to have intermediate semiconductive paths of the largest energetic gap.

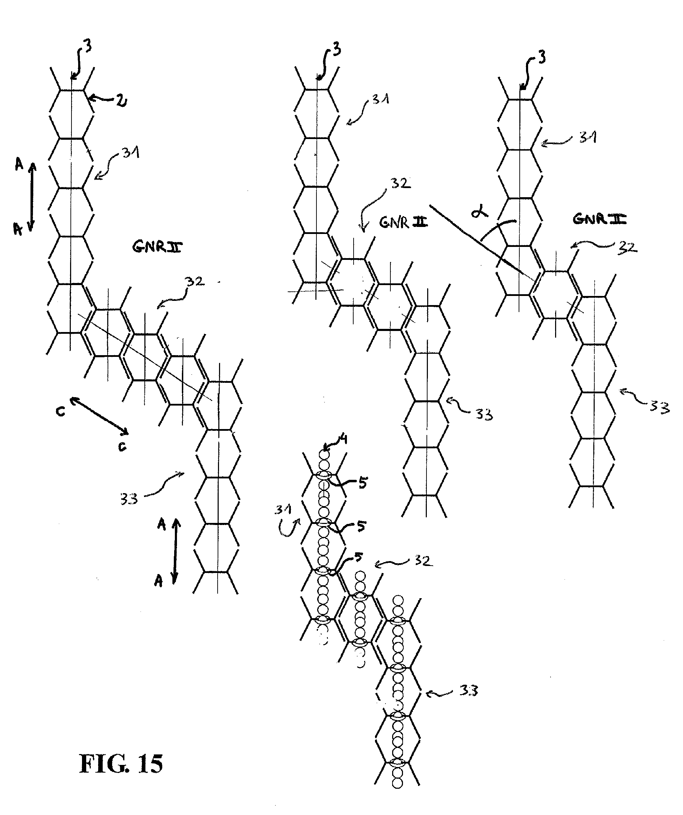

A schematic plan view of GNRs built from a chain of ECNFs with 3 one-channel paths (two superconductive 31, 33 and one semiconducting 32), patterned from figure 12, is shown in figure 15 in the interests of simplicity and clarity.

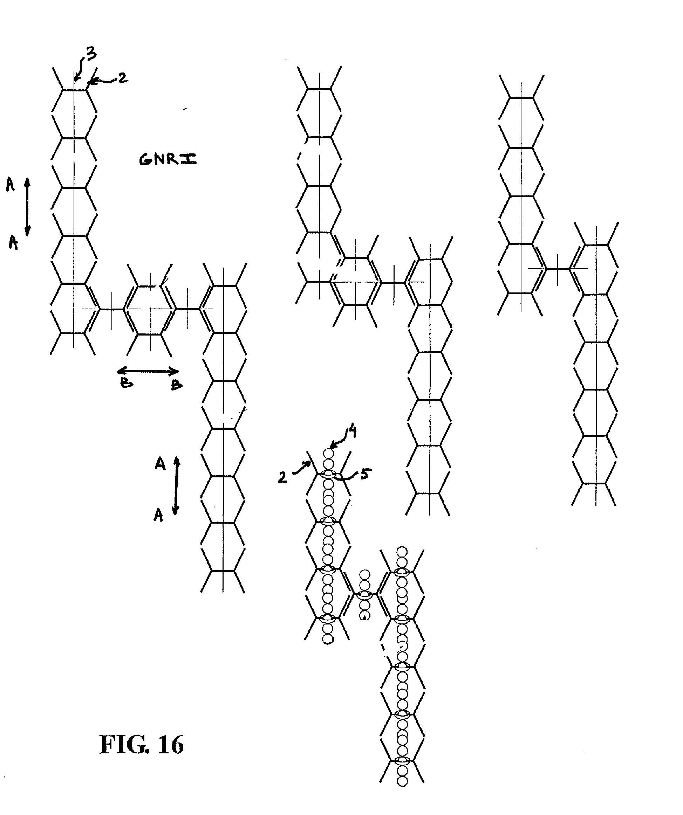

A schematic plan view of GNRs of one-chain ECNFs, similar to the one shown in figure 15, with one-channel paths but patterned from GNRs of the kind presented in figure 14 (a semiconductive path is along the direction B-B as designated in figure 9) is shown in figure 16.

With this invention, the five following main kinds of elementary GNRs can be distinguished:

The first ones are straight GNRs carved directly in the superconducting direction A-A (figure 7B); they will be designated further as GNR(A).

The second ones are also straight GNRs but carved in the perpendicular direction B-B with respect to superconducting A-A (figure 7A); they are designated further as GNR(B).

The third ones are curved GNRs obtained from graphene sheets by carving in the A-A-B-B-A-A direction (14, 16); they are designated further as GNR (I).

The forth ones are curved GNRs obtained from graphene sheets by carving in the A-A-C-C-A-A direction (figures 12, 15); they are designated further as GNR (II).

The fifth one are curved GNRs obtained from graphene sheets by carving in the A-A-D-D-A-A direction (not shown); they are designated further as GNR (III).

Other complex kinds of GNRs are merely the combinations of the above main kinds.

The electronic band structure significantly differs in the indicated directions.

With the same width of a GNR, the larger angle $\alpha$ (figure 15) between A-A and the orientation of intermediate paths, the larger the energy gap in them. The longer these paths, the more additional detrimental scattering for charge carriers will take place.

A schematic view of a field-effect device (FED) comprising a GNR I of the kind illustrated in the figure 12 in accordance with one embodiment of the invention is shown in figure 17..

This figure 17 represents additionnally to the figure 12, a drain electrode 51 and a source electrode 53 connected respectively to the two superconducting portions 31, 33 of the GNR I, and a gate electrode 52 connected to the intermediate semiconducting portion 32 of the GNR I.

Figure 17A illustrates a cross sectional view of FED of figure 17 showing the unique graphene layer constitutive of the three drain 31, gate 32 and source 33 portions, and the substrate on which they are disposed, which is composed of a silicon layer Si overlapped by a silicon oxide layer $S_iO_2$. The drain 51 and source 53 electrodes are each overlaying both an extremity of the corresponding graphene ribbon portion 31, 33 and the silicon oxide layer $S_iO_2$. The gate electrode 52 overlaps a dielectric layer of silicon oxide disposed on the semiconducting portion 32 of the GNR. In this example, the drain 51, gate 52 and source 53 electrodes are made from a conducting metal, such as gold (Au). The FED comprises further a back electrode 55 fixed on the surface of the silicon substrate $S_i$ opposed to the GNR I.

The FED represented in figures 17 and 17A comprises a GNR of the type GNR(I) as an example, although other kinds of GNRs are also applicable.

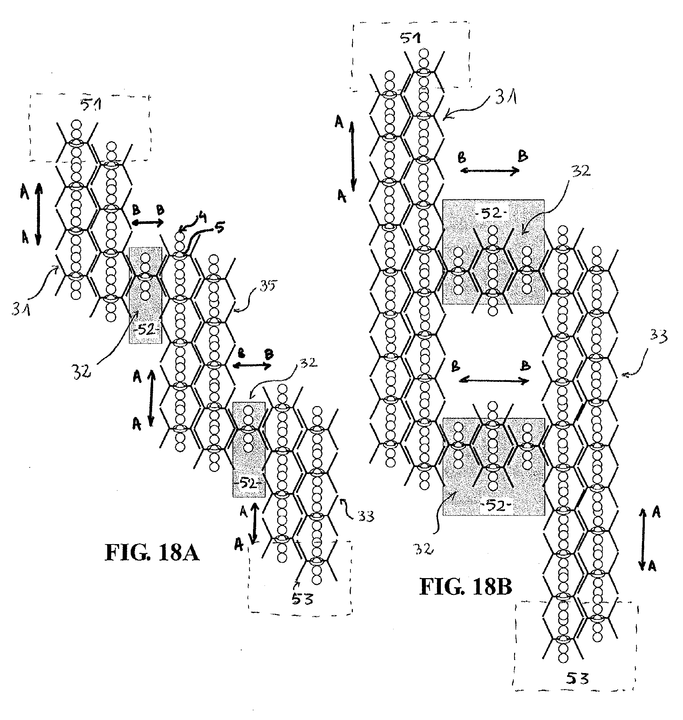

The schematic diagrams of two other exemplary configurations of FEDs made according to the invention, that take into account the ECNFs definite orientation inherent in the two-gate GNRs(I), are shown in figures18A,B.

The figure 18A shows a FED structure comprising two end ribbon portions 31, 33 oriented along the superconducting direction AA and connected respectively to a drain 51 and a source 53 electrode, and an intermediate portion 35 also oriented along the superconducting direction AA and connected to a gate electrode 52. The gate intermediate portion 35 is connected to each first 31 and second 33 ribbon portions by an ECNF oriented along the BB direction. A successive connection of the two gates 52 in figure 18A relates to FEDs realizing a logical operation "and" due to the 2 gate portions which are mounted in series.

The figure 18B is relative to a parallel connection of the two gates 52 and relates to FEDs realizing a logical operation "or". More precisely, in figure 18B two portions 31, 33 of GNR oriented along the direction of superconductivity AA and connected respectively to a Drain 51 and a source 53 electrode, are connected to one another by two portions 32 oriented along the direction of pure semiconductivity BB, each portion of pure semiconductivity 32 being connected to a gate electrode 52.

Intermediate paths (Gate 1 and Gate 2) of one ECNF every, shown in figure 18A, are the simplest tunnel junctions.

It is to be understood that the above (and below)-described arrangements are merely illustrative of many possible specific embodiments that can be devised to represent applications of the principles of the invention. Numerous and varied other arrangements can be devised in accordance with these principles by those skilled in the art without departing from the spirit and scope of the invention.

In particular, as discussed earlier, the FEDs of the figures 17-18A,B which are schematic views, are not restricted to the use of GNRs carved entirely from one and the same graphene sheet.

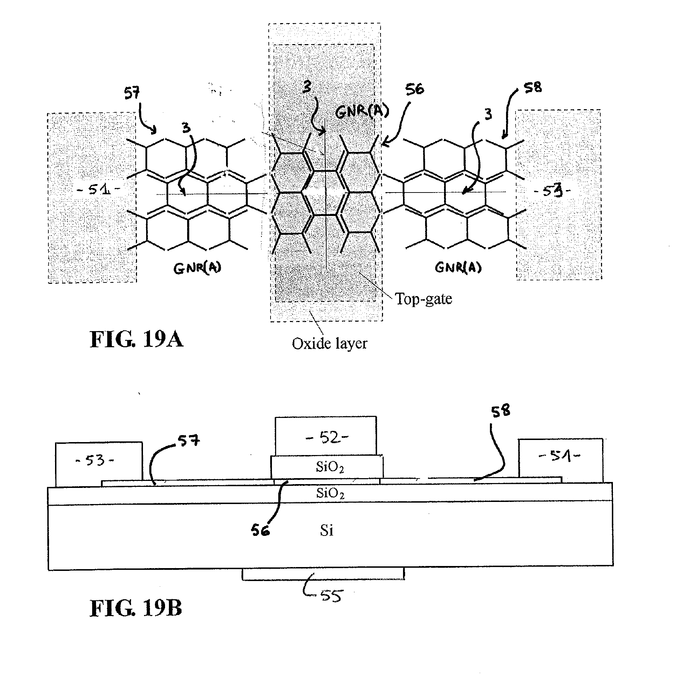

Indeed, as shown on the schematic view of the figure 19A three individual GNRs(A) are used to form a FED in accordance with another embodiment of the invention. An intermediate GNR(A) 56 (Graphene II) gate is placed perpendicularly to the two other GNRs(A) 57, 58 connected to the source 53 and drain 51, respectively. Such a structure can be obtained by applying of controlled Carbon Vapor Deposition (CVD) method and known scanning tunneling lithography

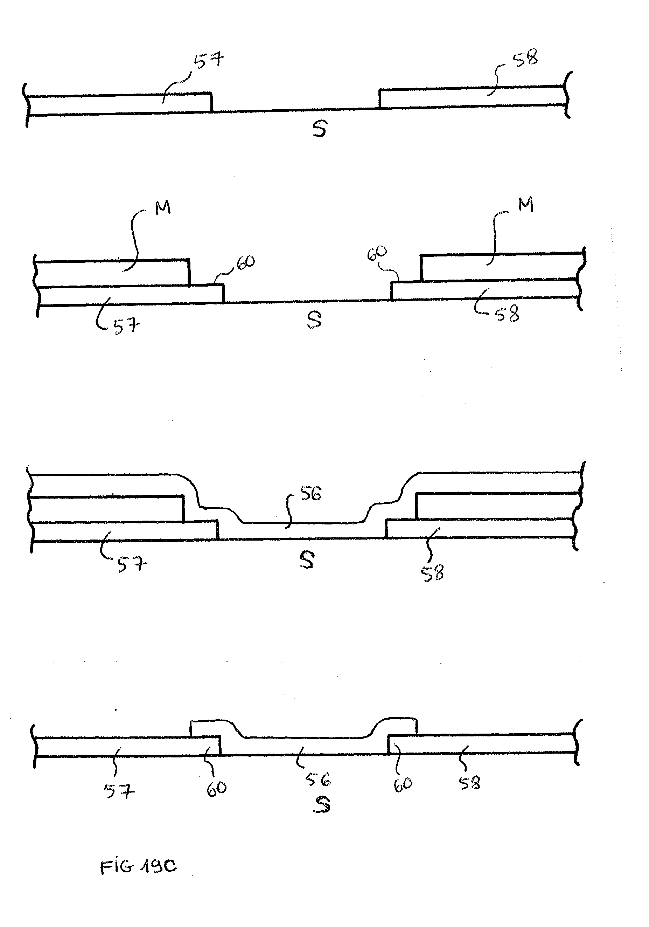

Figure 19A is a schematic top view of such a structure and the figure 19B is a schematical crossed view thereof which is identical to the one depicted in figure 17A apart from the layer of graphene which is in this figure 19A, consists in three individual GNRs 57, 56 and 58 whereas in figure 17A it consists in a unique GNR which is carved in a predetermined manner. It can be obtained by a method which is schematically shown in figure 19C.

This figure 19C shows in a first step the deposition on a substrate S of the drain 57and source 58graphene portions according to desired ones of the before defined orientations, with a space between them which is reserved for the formation of the gate portion 56.

In a second step, masks M are applied on the drain 57and source 58 portions letting free a boundary part 60 of each portion 57, 58.

A third step is made for depositing on the top of what is shown in the above second step a graphene layer having the desired orientation i.e. perpendicular to the one of the source 58 and drain 57 portions, and which will constitute the gate portion 56.

The fourth step results in etching away the lastly deposited gate graphene layer on the drain and source portions so that there remains only the graphene in the space between the source 57 and drain 58 portions and on the boundary areas 60 of the source 57 and drain 58 portions.

It is to be noted that the orientation of ECNFs which have the features of radicals can be controlled by applying appropriate electrical or magnetic field. Accordingly it is possible to get deposition of graphene in any of the above defined or required orientations.

Due to the above described method of manufacturing devices by assembling different individual graphene portions with overlapped portions 60, the junction between gate 56 and source 58 on the one hand, and the gate 56 and drain 57 on the other hand, can be obtained without discontinuities which do not affect the working of the device.

In the absence of overlapped portions 60 between three individual GNR portions, there is no discontinuity between two successive portions when they are separated from one another by a space of the atomic size.

The 3-GNR structure of FEDs of figure 19A is analogous to the 1-GNR FEDs structures presented in figures 14 and 17.

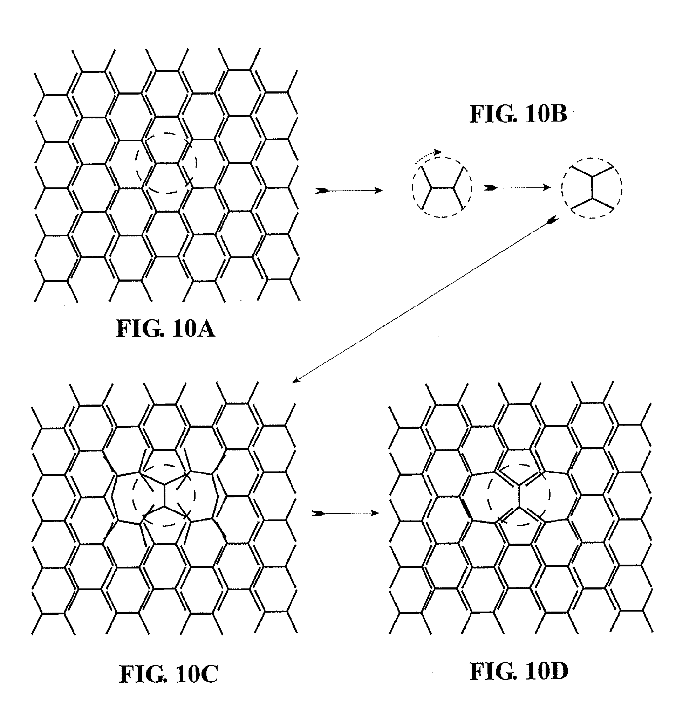

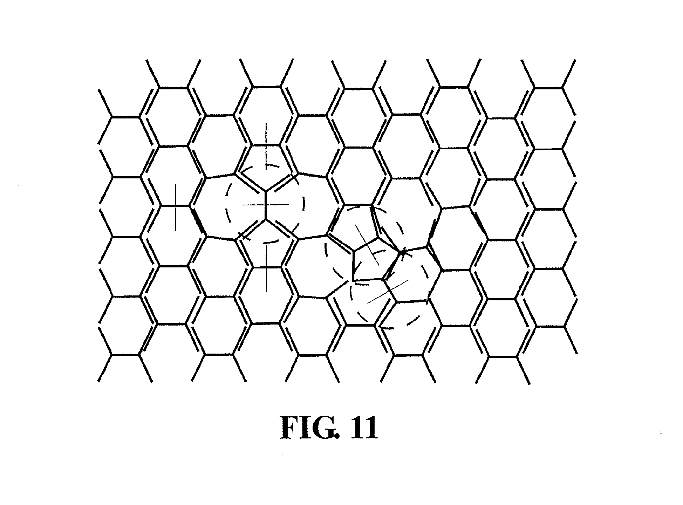

With this invention, the structure of graphene is strongly deterministic and affected to self-treatment as shown in figures 10A-D and 11.

However the 3-components structure of FEDs, such as shown in figures 19A,B, is not restricted to the use of only graphene material.

Indeed, in accordance to one more embodiment of the invention, a FED like device can be built from graphene and individual flat molecules having a structure that cannot be carved from a graphene sheet, for example one can use a benzene molecule 61 ($C_6H_6$), the latter having the form of a flat hexagonal ring, which is closed without strain. The benzene molecule 61 are formed from ECNFs in the way as shown in the figure 5A with the difference that channels 3 of ECNFs are not parallel one another but form an angle of 120° so that benzene molecule has three superconducting channels 3 in a star like configuration with an angle of 120° between them.

An ideal conjunction of all bonds conditions a large stability of benzene rings. A conditional designation of benzene with taking into account superconductive channels of constituent ECNFs is shown in figure 5C.

The benzene molecule 61 has a supplementary feature according to which it can act as a closed superconductor ring formed by the empty nodes disposed in the center of the hexagonal ring.

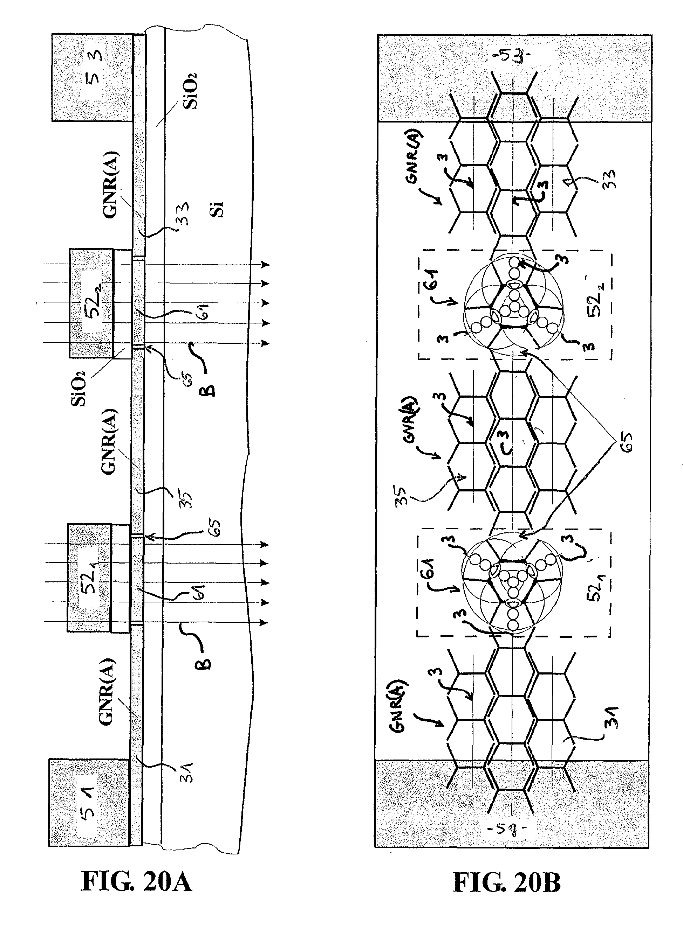

In accordance with yet another embodiment, the schematic views of a 2-gates (taken just as an example) FED, built on the basis of graphene and a benzene molecule, are shown in figures 20A,B.

Magnetic fields B are shown here as gate control means. This magnetic field can be used to control the charge carrier flow additionally to or instead of electric bias voltages applied between the top and back gate electrodes.

Benzene molecules 61, being closed circular superconductors, serve as traps for charges that are revolving in them when an external magnetic field (or a high frequency electromagnetic field) is applied over the benzene hexagonal ring area. Benzene molecules 61 can be regarded in this case as quantum dots, and an entirely system, shown in figures 20A,B, as a single-electron 2-gates transistor circuitry.

In a more detailed manner, figures 20A,B show a structure comprising a first graphene GNR(A) having the orientation A constituting a source portion 31, a first gate portion formed from benzene molecule 61, a second graphene ribbon portion GNR(A) 35, a second gate portion formed by benzene molecule 61 and a drain portion 33 with GNR(A). The three GNR portions 31, 35, 33 and the benzene molecule 61 are deposited on a silicon oxide layer $S_iO_2$ overlapping a silicon substrate $S_i$. Two gold electrodes acting as a drain 51 and as a source 53 are connected to the drain 31 and source 33 portions and two gate electrodes $52_1$, $52_2$ made also from gold, are connected to the benzene molecules 61 via a dielectric layer of silicon oxide. In the absence of magnetic field B, the device works as a FET of figure 19A. Upon application of a magnetic field B on the gates $52_1$, $52_2$, electrons which have passed from the source portion 53 to the benzene molecule 61 through the tunnel junction will be trapped in the circular path of the benzene ring formed by the empty nodes 4 located inside the hexagonal lattice of the benzene molecule 61 and accordingly, are impeded to move to the drain portion 51 until the magnetic field is switched off and the above mentioned working conditions of a FET are reestablished.

It is to be noted that the intermediate portion between the two gates can work in the absence of magnetic fields as a quantum dot because it is limited on both sides by tunnel junctions 65 controlled by the two bias voltages of the gates $52_1$, $52_2$ and due to the fact that the width is in the atomic size order level which is determined by the quantum law.

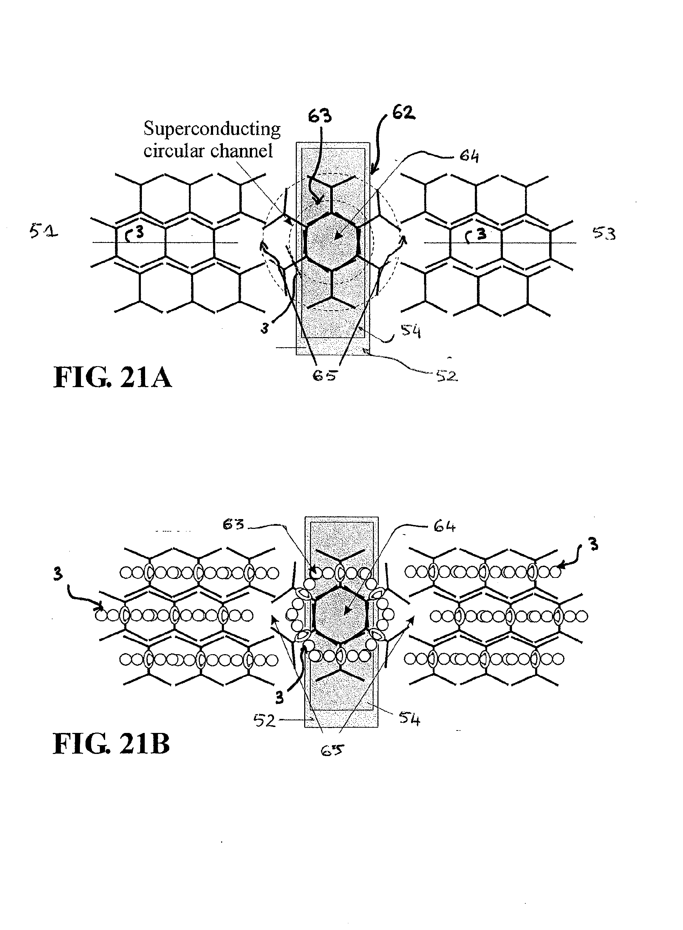

Schematic views of a field-effect device in accordance with yet another embodiment of the invention are shown in figures 21A,B. A molecule used in this case, between two GNRs(A), is a carbon formation constructed from 6 ECNFs, with 12 active external bonds. It may be a $C_{12}H_{12}$ cyclic molecule 62. A carbon skeleton of the molecule has a closed circular "spine", a superconducting circular channel 63 formed from six joined ECNFs superconducting channels. This makes it possible to use the molecule as a quantum dot 64 in different FEDs. figure 21A and figure 21B are the same schematic views but presented by the 2 symbolic designations of ECNF (See, figure 4C). The gate 52 is provided with a gate capacitor 54 due to the interposition between the gate electrode and the molecule of a dielectric layer, as shown on the sectional views for instance in figure 19B. The tunnel junctions between the superconductivity channels 3 of each GNR(A) and the circular superconducting channel 63 of the molecule 62 are referenced by 65.

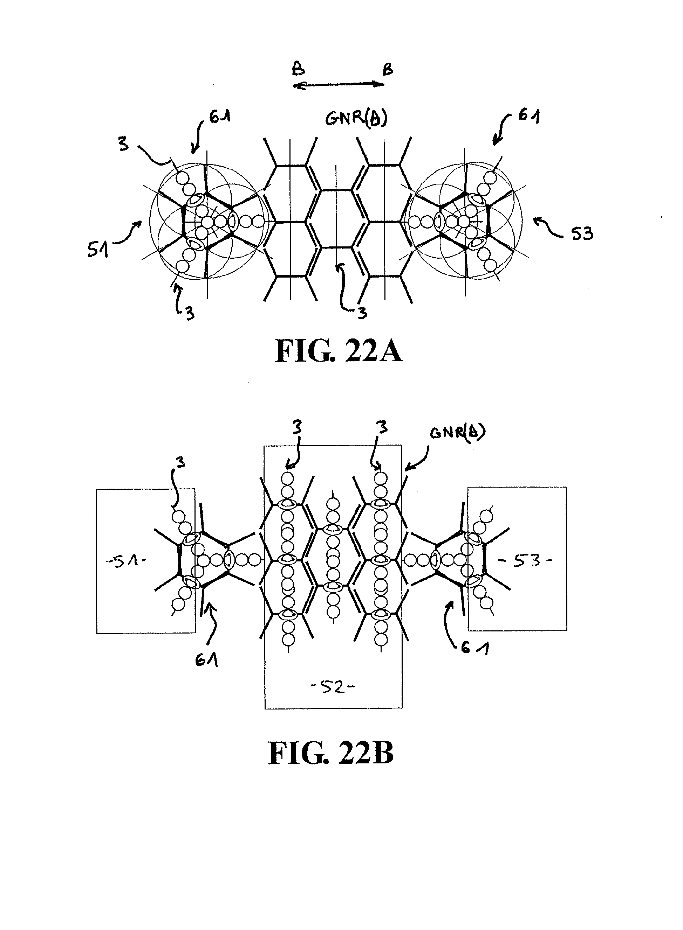

A schematic view of FED in accordance with a yet more embodiment of the invention is shown in figure 22A and 22B. The two benzene molecules ($C_6H_6$) 61 are used in the FED as a superconducting source 53 and drain 51. A GNR is positioned in a semiconductive direction B-B (See, figure 9) with respect to a charges flow. Figure 22A and figure 22B are the same schematic views but presented by the 2 symbolic designations of ECNF (See, figure 4C).

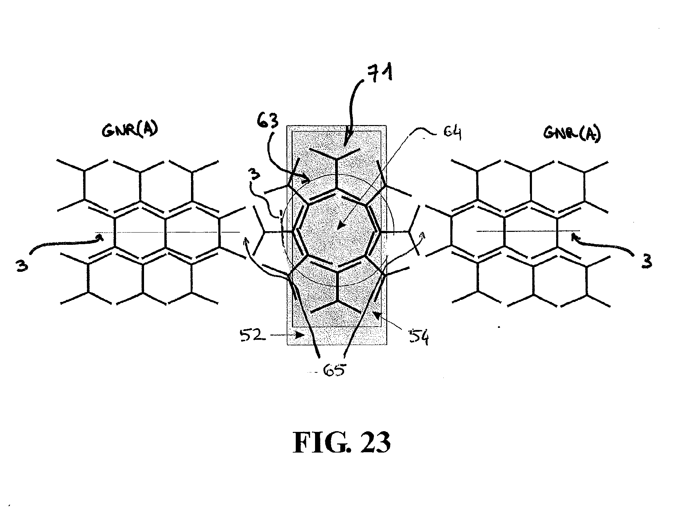

A schematic view of FED in accordance with yet another embodiment of the invention is shown in figure 23. A molecule 71 used in this case, along with 2 GNRs(A), is a carbon formation constructed from 8 ECNFs, with 16 active external bonds. It may be a $C_{16}H_{16}$ cyclic molecule 71, one from myriad planar hexacoordinate carbon molecules already obtained or will be synthesized. A carbon skeleton of the molecule has a closed circular superconducting channel 63 formed from eight joined ECNFs channels 3. This makes it possible to use the molecule as a quantum dot 64 in different FEDs.

Another molecule of particular interest is coronen 75 ($C_{24}H_{12}$), a light-yellow crystal substance with a melting point of 440°C and sublimation temperature of 100°C. It is obtained by several methods.

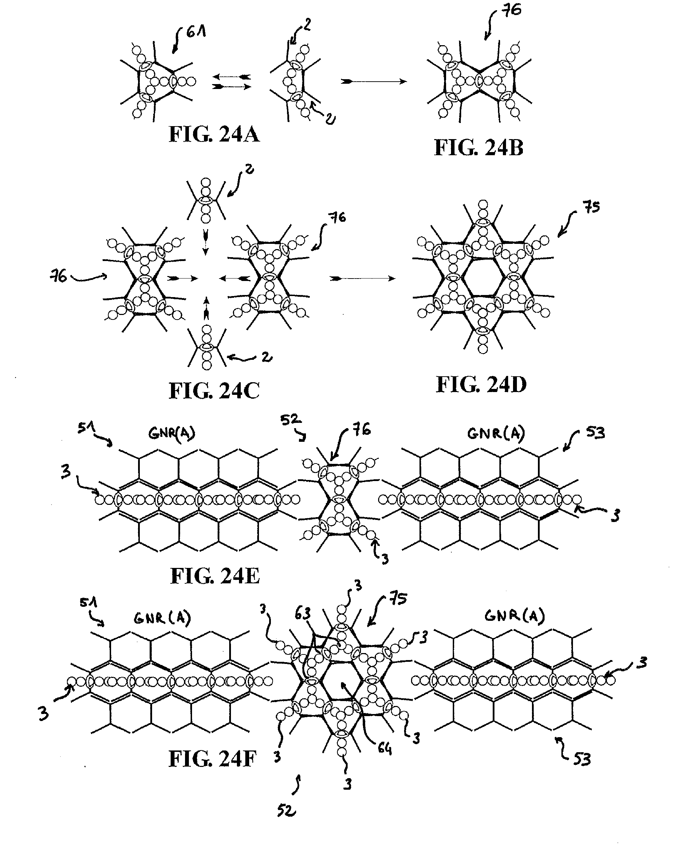

Coronen has exclusive thermo-stability and physical properties. A crystal structure of coronen can be presented as consistent of two stacked naphtene molecules 76 ($C_{10}H_8$) bridged by two ECNFs 2 as shown in figures 24C, D. A naphtene molecule 76 can be presented as consistent of a benzene molecule stacked with 2 bonded ECNFs as shown in figures 24A, B.

A basic structure of FEDs is a triad of source 53, gate 52, and drain 51. The triads use as the gates 52, the naphtene 76 and coronen 75 molecules as shown in the figure 24E and figure 24F, respectively. Topology of superconducting channels 3, 63 is clearly seen from the Figures

Tunnel barriers between source 53/drain 51 and gate 52 have the same nature in both schemes but differ in value because of a different number of naphtene molecules 76 (1 and 2, respectively) constituting the gate parts of the triads. A coronen molecule serves here as a quantum dot 64.

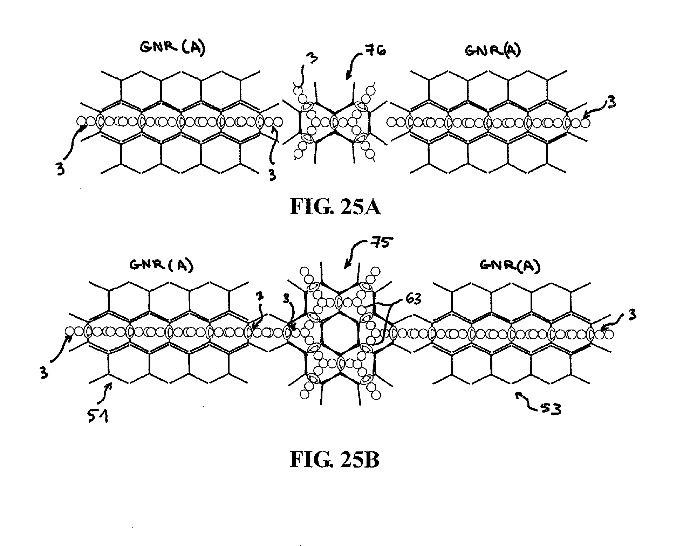

Naphtene 76 and coronen 75 molecules oriented in another way with respect to superconducting channels 3 of source 53/drain 51 are shown figures 25A,B. There are no barriers at the junction of the superconducting circular channel 63 of coronen 75 with the channels 3 of GNR(A). Accordingly, physical features of FEDs devised on the basis of such a mutual disposition of 3 parts of the triad will be different from that inherent in the previous case.

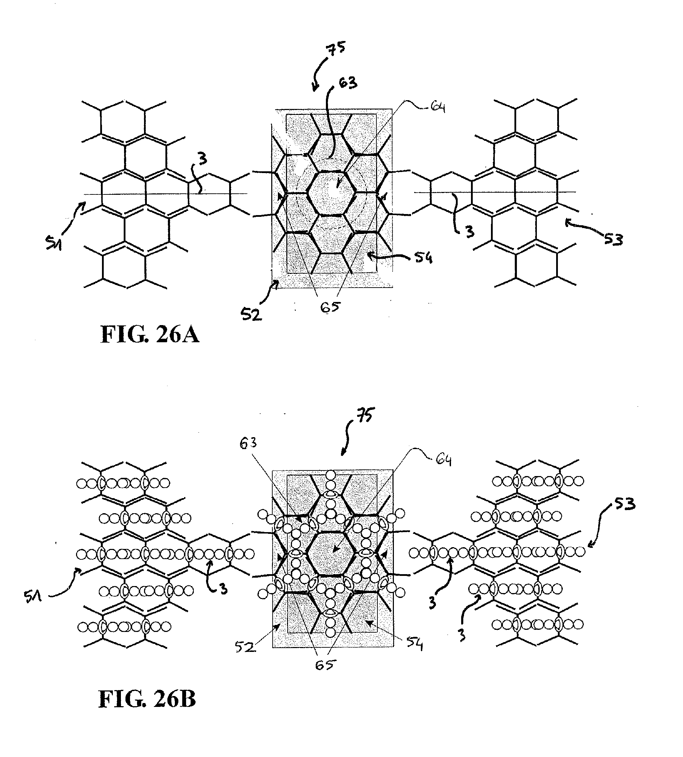

In figures 26A,B in comparison with figure 24F, there are shown some more details of the gate portion 52 of the structure of FEDs based on the same triad, in the interests of more clarity.

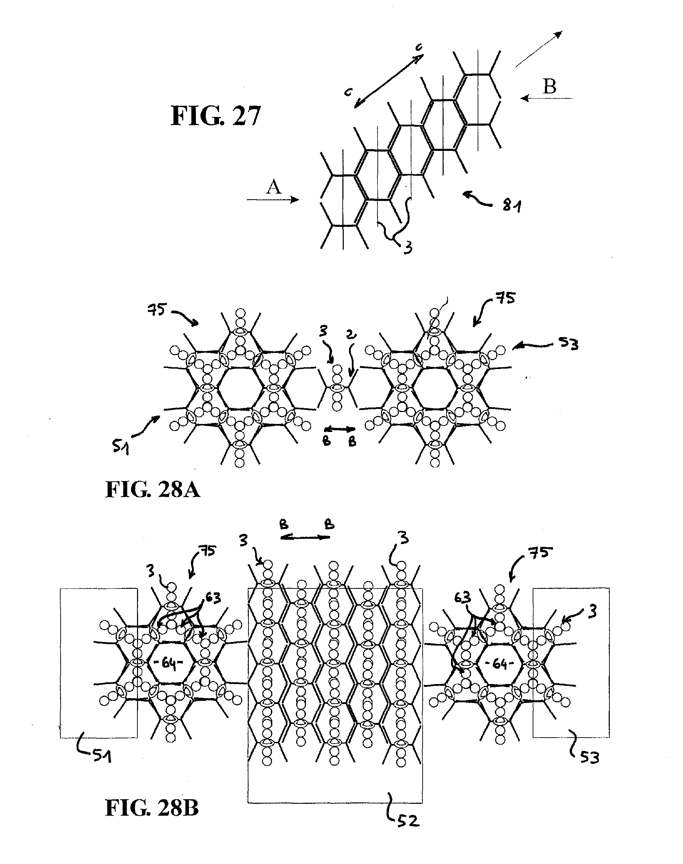

Instead of coronen, other plane molecules can be used in the schemes presented above, for example, quinacridone. Quinacridone 81 is a pigment with a linear type structure. A schematic view of a carbon basis of quinacridone in view of its ECNF structure is shown in figure 27. From the figure it follows that the quinacridone carbon structure resembles one-channel GNRs(C) carved in the direction C-C from graphene (see figure 9) having, as was mentioned earlier, semiconducting properties. Tunneling spectroscopy confirms that a one-dimensional chain of quinacridone is semiconducting. An energy gap calculated is about 3.06 eV [See, A. Susanto et al., Ab initio study for structure, electric properties and light emission of linear-trans-quinacridone, The European Physical Journal D 38, 1, 199-201 (2006)]. Every quinacridone molecule has two positions to create bonds bridging the neighboring molecules that are indicated by arrows A and B in figure 27.

Coronen molecules used as source 53 and drain 51 in FEDs are schematically shown in figures 28A, B. The gates are presented, correspondingly, by a ECNF (in figure 28A) and GNR(A) (in figure 28B) joined in a crystallographic direction B-B (as indicated in figure 9) coronen molecules.

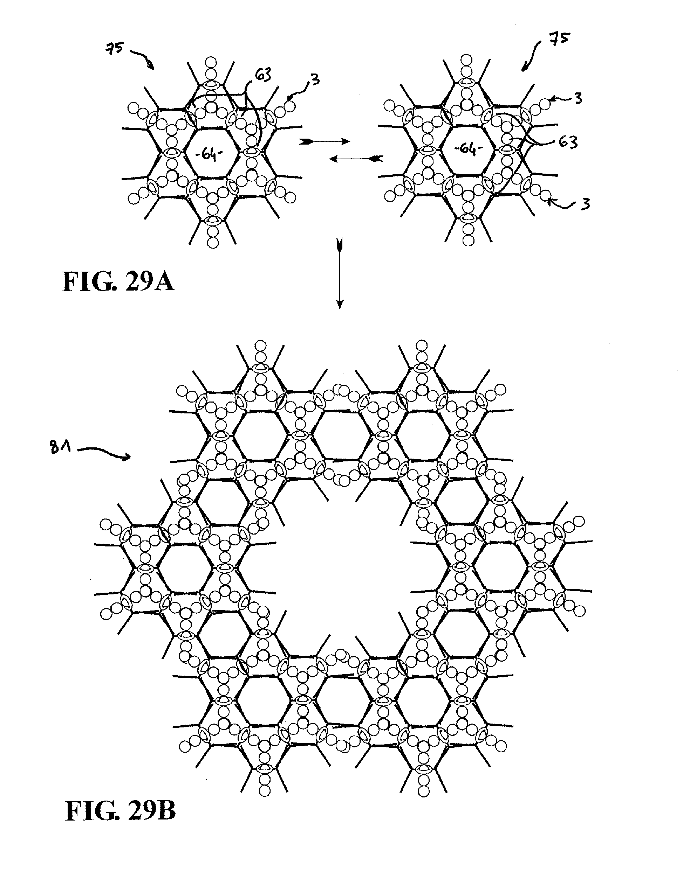

Because of self-assembly inherent in coronen molecules under definite conditions, they form the definite two-dimensional plane structures, which can be used as integrated elements ready for nanodevices. One of such structures formed from 6 coronen molecules 75 is shown in figure 29B. Binding of the molecules is realized through the bonds as indicated in figure 29A. As a result we have a rigid symmetric structure, stable and unstrained 81.

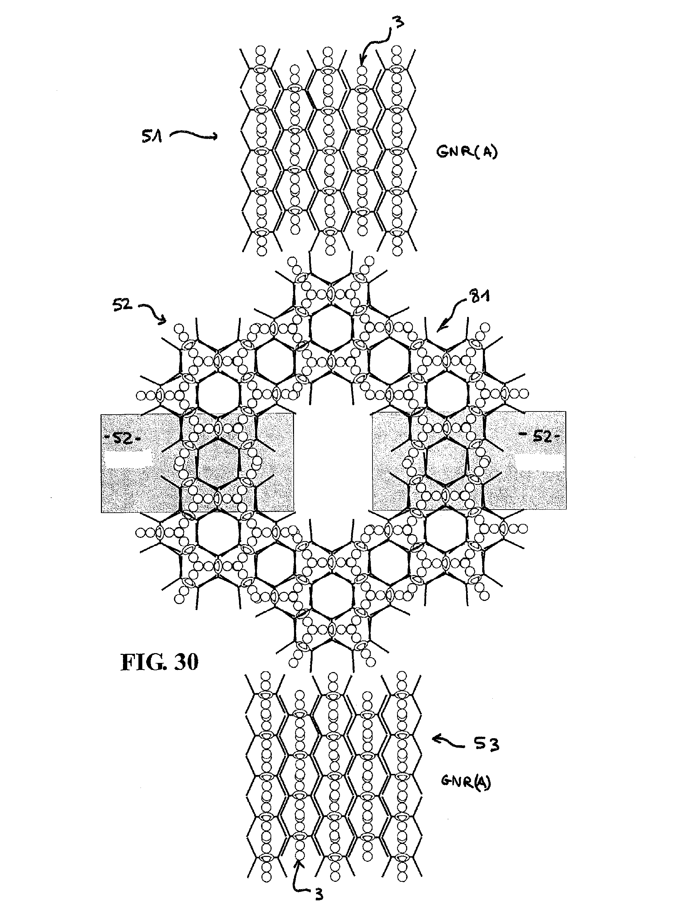

A schematic view of FED on the basis of the 2-dimensional coronen structure of 6 coronen molecules 81 (see figure 29B) and 2 GNRs(A) is shown in figure 30. It is a FED with 2 parallel gates 52.

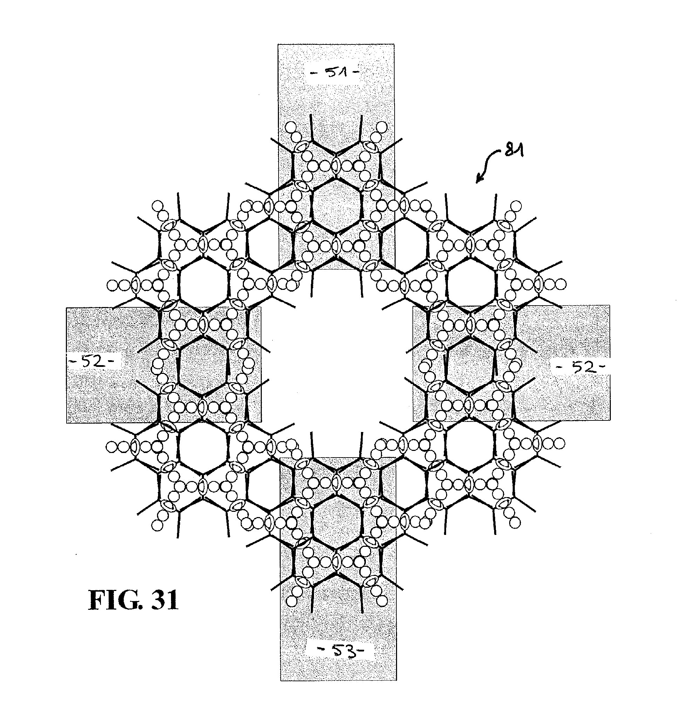

With this invention, a principal scheme of a nanoelectronic device of the 2 paralleled gates made on the basis of an only above-depicted (see figure 29B) coronen structure 81 is shown in figure 31.

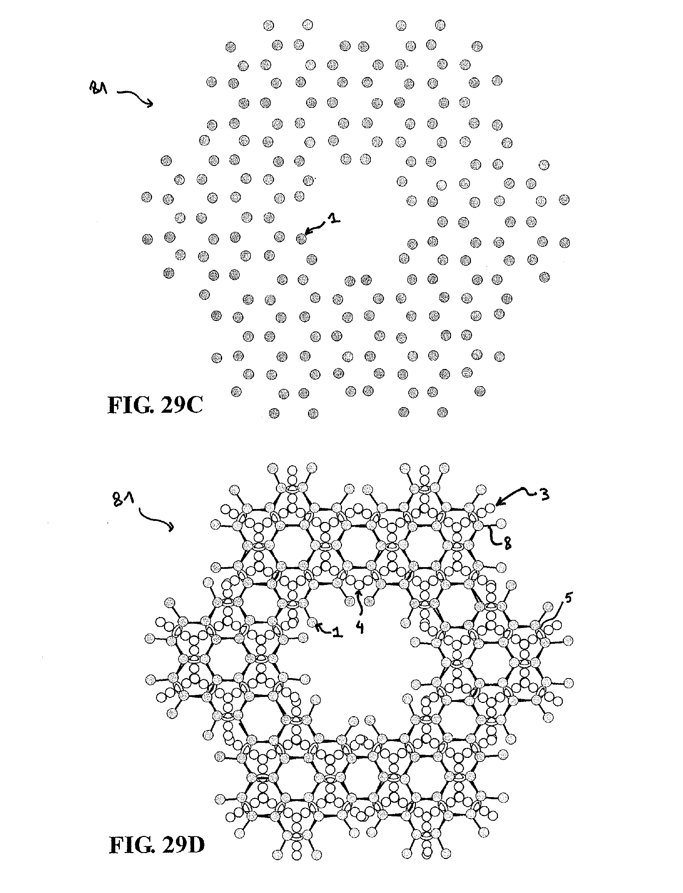

A disposition of crystal nodes in a two-dimensional crystal structure, schematically shown in figure 29B, which are visible by microscope and in micrographs, is presented in the figure 29C. A drawing of both, a schematic view of the (invisible) structure, including internodal bonds and a superconducting channel network, shown in figure 29B, and the disposition of crystal nodes (visible) therein, shown in figure 29C, is presented in figure 29D

As was earlier mentioned, nature uses the method of self-assembly, self-organization that resulted in complexity of nature. Coronen is a self-assembling molecule where self-assembly works on a nanoscale. Like carbon and hence ECNF, coronen forms two-dimensional crystals on surfaces that are actually gigantic 2-D molecules of a specific mosaic. Thus growing is a deterministic process. It is predictable now for carbon based crystal structures because we know the crystal structure of their elementary building blocks, ECNF. The atomically thin coronen sheets are stable under ambient conditions, exhibit high crystal quality, and are continuous on a macroscopic scale.

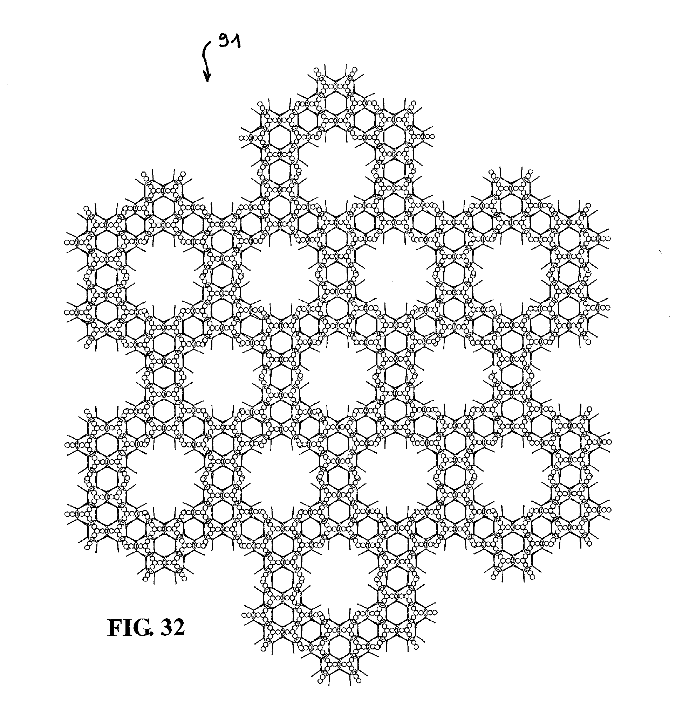

In accordance with one of the aspects of the invention, it is preferable to use, along with 2-D graphene sheets, the 2-D coronen sheets - a coronen network, which fragment formed from 7 joined coronen structures depicted in figure 29B, is shown in figure 32. A developed system of joined superconducting channels, revealed from the structure presented, allows patterning manifold electronic devices on the coronen sheets by the same methods as it is made currently on graphene sheets. A whole net of superconducting channels is a continuous junction of circular channels of individual coronen molecules. Possibilities for tailoring the atomic structure of new configurations carbon nanoobjects by scanning tunneling microscope lithography increases with use of the coronen sheets.

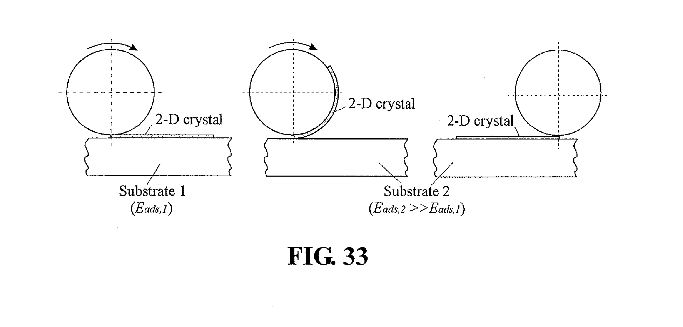

To fabricate the 2-D coronen sheets it is necessary first to select a substrate with the lowest adsorption energy as possible, otherwise it will be impossible to realize growing of the coronen crystal. A suitable substrate, for example, is graphite (found for this case by W. M. Heckl [See, W. M. Heckl, Molecular Self-Assembly and Nanomanipulation - Two Key Technologies in Nanoscience and Templation, Advanced Engineering Materials 6, 10, 843-847, 2004]). Second, the scanning probe microscopy techniques (in particular scanning tunneling microscopy, STM) must be used for seeing positions of coronen molecules and for positioning them, if it is necessary, by the microscope tip designed in an appropriate way for this aim. High-resolution transmission electron microscopy (HRTEM) may also be useful for primary identification of the character of arising bindings. The third stage is transfer of the obtained coronen crystal on top of an oxidized Si wafer. The higher adsorption energy $E_{ads}$ of the coronen crystal on a $SiO_2$ layer allows its perfect transfer from the graphite substrate (or from other ones if they will be used for growing). Three stages of one of the imprinting on methods are schematically shown in figure 33.

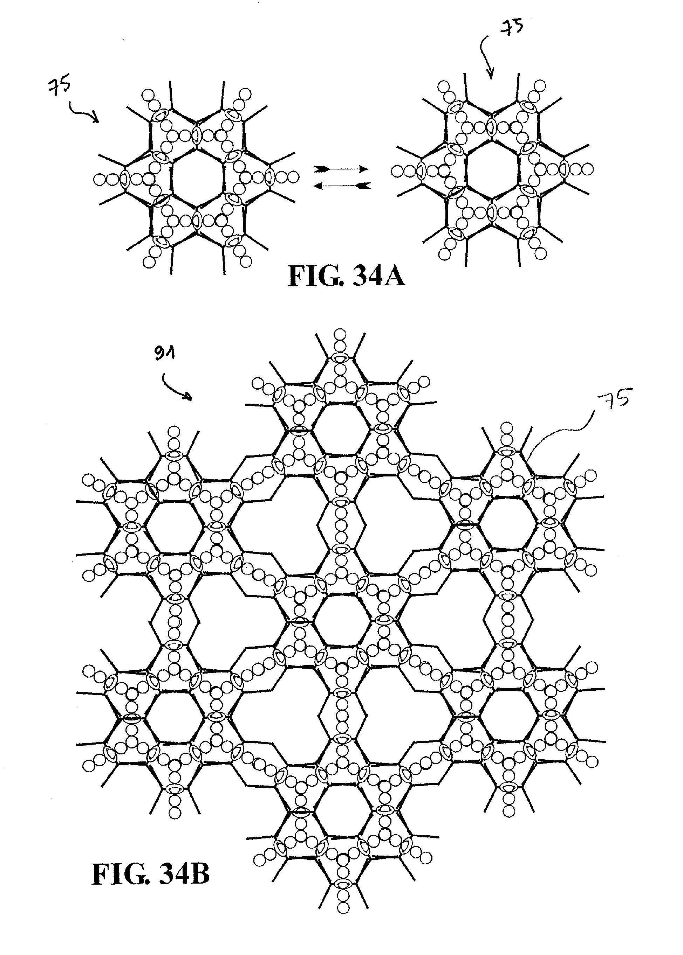

Coronen molecules can be joined also by one more way as indicated in figure 34A. In this case, a 2-D crystal structure resulted in junction of 7 coronen molecules is schematically shown in figure 34B.

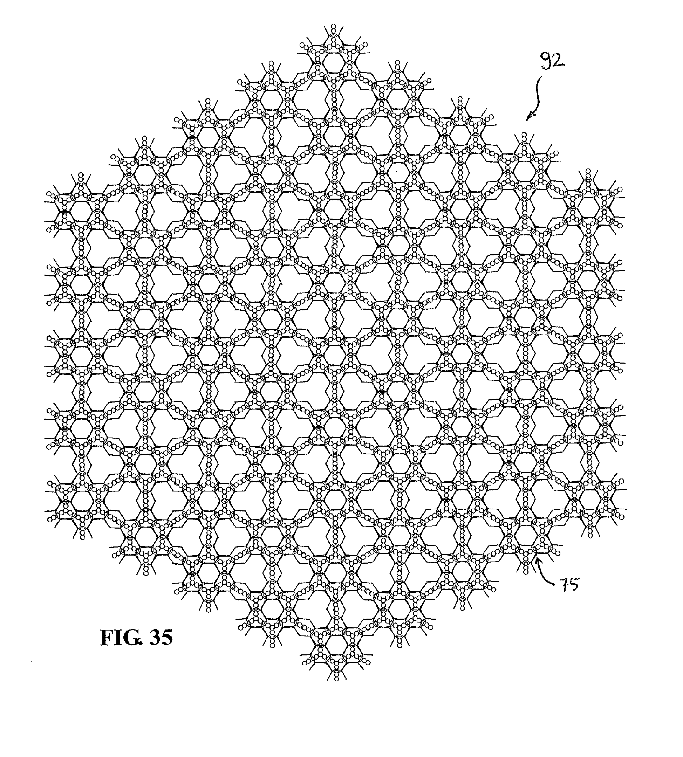

A schematic view of a fragment of a coronen crystal network 92 formed by binding of coronen molecules 81 as indicated in figures 34A,B is shown in figure 35. The structure of superconducting channels shown here differs from the structure shown in figure 32.

With this invention, taking into account the structure of constituent ECNFs, it is revealed a plan (mosaic) of a superconducting network in observed crystal structures. The latter serves as the basis for rational patterning and lithography processes, and accordingly, for the controlled fabrication of nanoelectronic devices and integrated circuits with predetermined electronic properties.

Furthermore, the knowledge of the ECNF according to the invention gives an explanation of the origin of SW defects, which is important for basic understanding of this novel material as well as for potential electronic, mechanical, and thermal applications.

Indeed, there is a minimal total energy of all bonds in an ideal graphene lattice because an ideal conjugation of all nodes and internodal bonds yields to a gain in energy; such is the nature of formation of all compounds.

So in the case of deviation from the aforementioned regularity, happened for some reasons, it takes place a lost of (deviation from) thermodynamic stability resulting in metastable defects.

Typical metastable defects inherent in graphene are two pairs of five- and seven-membered rings of carbon nodes (pentagon-heptagon (5-7) defects) called Stone-Wales (SW) defects. The main stages of their formation are schematically shown in figures 10A-D. These defects spontaneously appear in a hexagonal graphene lattice and remain stable for a time.

In electron microscopy conditions, under electron beam affects, the time takes about several or tens of seconds depending on electron energy.

A process of the formation of the defect is the following. First of all it should be noted that all nodes in ECNF are in a plane, but as a whole ECNF has a spherical space structure with two spherical shells, internal and external.

The 2 internal and 4 external nodes are, respectively, on these shells. ECNFs and their nodes continuously oscillate around an equilibrium state with amplitude depending on the temperature.

At room temperature graphene is stable, and Figure 10A shows schematically an unperturbed lattice before an appearance of the defect.

A dash circle indicates the disposition of the ECNF selected for the consideration in the interest of clarity.

Under influence of the electron beam, of a different dose and voltage, the ECNF temperature and, hence, amplitude of oscillations increase. J. C. Mayer et al. note in a recent article in Nano Letters, "The maximum energy that can be transformed from an 80 keV electron to a carbon atom is 15.6 eV, which is below the threshold for knock-on damage but sufficient to form multiple SW defects".

The perturbation appeared results in elastic deformation and weakening of internodal bonds, their local breaking, and leads to turning of the ECNF in a plane around the axis passed through its center of symmetry perpendicularly to the plane as shown in figure 10B. figure 10C shows a relative position of the ECNF just after breaking of equilibrium bonds and turning along the angle of $\pi/2$. All internodal bindings in ECNFs are elastic, and their break after ultimate deformation (bending) of them in the turned ECNF, due to oscillating with a big amplitude, and the surrounded ECNFs results in a new configuration of metastable bonds, and in an appearance of a joined pair of pentagon-heptagon (SW) defects as shown in figure 10D. The defect appeared is metastable because all new bonds formed are strained in some extent because of deformative bending them from thermodynamically equilibrium state.

The above-described process shown in figures 10A-D is reversible. After a relaxation time the defect disappears because of the reverse process, internodal bonds return to the thermodynamically equilibrium state, i.e. to the unperturbed ideal graphene crystal lattice structure.

A schematic view of the dynamics of the SW defect appearance, shown in figure 10D, completely agrees with the direct experimental images presented in the above-referred article published in Nano Letters (see Figures 3a-d, herein).

Figure 11 shows a resulting formation of another complex metastable defect, like shown in figure 10D but with 4 pairs of five- and seven-membered rings of carbon nodes. The latter completely agrees with the direct experimental images of such a kind of the defects shown in the above-referred article in Nano Letters (herein, in Figures 3h,I).

Here we see the 3 ECNFs turned in plane by the different in value angles from their equilibrium states so that directions of their Z-axis are essentially changed. Their positions are market by the dash circles. So an appearance and disappearance of the defects in graphene means that ECNFs are mobile being in a continuous oscillatory motion. Their nodes only rebuild their bonds with neighboring nodes, so that in this case ECNFs (and hence, carbon atoms) do not escape. A relatively low excitation of the obtained structure is needed to stimulate a process of self-treatment of arisen defects. After relaxation, a graphene lattice returns to an ideal unperturbed stable state.

**Claims**

1. Method for manufacturing nano electronic devices made from at least one planar carbon based molecule, comprising the steps of:

   - identifying in an elementary indivisible nanoformation (ECNF) (2) of the planar carbon based molecule, relations between predetermined axis of orientation (AA, BB, CC, DD) with respect to a reference orientation and physical properties such as electric current conduction properties,
   - realising devices having predetermined ones of said properties by positioning the ECNF (2) therein according to the orientations (AA, BB, CC, DD) corresponding to said properties.

2. Method according to the claim 1, wherein a said ECNF (2) is identified on an image as an entity of six nodes (1) with three nodes (6, 7) on each side of a first symmetric axis (ZZ'), arranged in a V like configuration that is symmetrically about a second axis (YY') perpendicular to the first axis (ZZ'), the two V like configurations of three nodes (6, 7) pointing to each other.

3. Method according to the claim 2, wherein in the orientation of the first axis (ZZ') the ECNF (2) is recognized as to have superconducting properties.

4. Method according to the claim 2 or 3, wherein in the orientation of the second axis (YY') the ECNF (2) is recognized as to have semiconducting properties.

5. Method according to one of the claims 2 to 4, wherein for obtaining a device including a portion having superconducting properties between two different polarising potentials, at least one ECNF (2) of this portion is positioned with its superconducting channel (3) parallel to the direction defined by the two different polarising electric potentials.

6. Method according to one of the claims 2 to 5, wherein for obtaining a device including a portion having semiconducting properties between two different polarising potentials at least one ECNF (2) of this portion is positioned with one of its orientation different from superconducting orientation (AA) between two different polarising potentials.

7. Method according to one of the claims 2 to 6, wherein the orientation of superconductivity is defined as a direction parallel to "zigzag edge" (24) of a sheet of carbon atoms crystal.

8. Method according to one of the claims 2 to 7, wherein the semiconductivity orientation is defined as being parallel to an "armchair edge" (25), a "C like edge" (32) or a "hook like edge" (27) of a carbon based sheet crystal.

9. Nano electronic device made from at least one planar carbon based molecule, manufactured in accordance to any of the preceeding claims 1 to 8, wherein planar carbon atom based sheet portions are arranged in orientation with respect to one another corresponding to predetermined polarisation.

10. Nano electronic device according to claim 10, wherein in a field effect kind device, a portion (32) electrically polarised in a semiconducting orientation is arranged between two portions (31, 33, 51, 53) electrically polarized in a superconducting orientation.

11. Nano electronic device according to claim 9 or 10, wherein the said at least planar carbon based molecule in which the nano electronic device is made from, is chosen among graphene, naphtene, coronen, benzene or quinacridone molecules.

12. Nano electronic device according to claim 10, wherein the said portion (32) electrically polarised in a semiconducting orientation and arranged between two portions (31, 33, 51, 53) electrically polarized in a superconducting orientation, is a planar carbon based molecule controllable by a magnetic field (B) so as to act as a trap for electron, such as a benzene (61) or a coronene molecule (64).

13. Nano electronic device according to claim 9, constituting a quantum dot and comprising three portions (31, 35, 33) electrically polarized in a superconducting orientation, the two end portions forming respectively a drain (31) and a source (33) portions, connectable to a drain (51) and a source (53) electrodes, the intermediate portion (35) being connected to the two end portions (31, 33) via two planar carbon based molecules controllable by a magnetic field (B) so as to act as a trap for electron, such as a benzene (61) or a coronene molecule (64), the intermediate portion (35) defining with each molecule controllable by a magnetic field (61, 64), a tunnel junction (65).

FIG. 1

**FIG. 2**

**FIG. 3A**

**FIG. 3B**

**FIG. 4A**

**FIG. 4B**

**FIG. 4C**

OR

**FIG. 4D**

FIG. 5A

FIG. 5B

FIG. 5C

**FIG. 6A**      **FIG. 6B**      **FIG. 6C**

**FIG. 7A**

**FIG. 7B**

**FIG. 8**

**FIG. 9A**

FIG. 9B

FIG. 10B

FIG. 10A

FIG. 10C

FIG. 10D

FIG. 11

EP 2 221 874 A1

GNRⅡ

**FIG. 12**

23

FIG. 13

**FIG. 14**

**FIG. 15**

**FIG. 16**

GNR I

FIG. 17

FIG. 17 A

**FIG. 18A**

**FIG. 18B**

**FIG. 19A**

GNR(A)

Top-gate

Oxide layer

**FIG. 19B**

FIG 19C

**FIG. 20A**

**FIG. 20B**

**FIG. 21A**

**FIG. 21B**

**FIG. 22A**

**FIG. 22B**

**FIG. 23**

FIG. 24A

FIG. 24B

FIG. 24C

FIG. 24D

FIG. 24E

FIG. 24F

FIG. 25A

FIG. 25B

**FIG. 26A**

**FIG. 26B**

**FIG. 27**

**FIG. 28A**

**FIG. 28B**

**FIG. 29A**

**FIG. 29B**

FIG. 29C

FIG. 29D

**FIG. 30**

FIG. 31

FIG. 32

2-D crystal

2-D crystal

2-D crystal

Substrate 1
($E_{ads,1}$)

Substrate 2
($E_{ads,2} >> E_{ads,1}$)

**FIG. 33**

**FIG. 34A**

**FIG. 34B**

FIG. 35

Fig. 36

Europäisches
Patentamt

European
Patent Office

Office européen
des brevets

# EUROPEAN SEARCH REPORT

**Application Number**

EP 09 15 3539

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | QIFENG LIANG ET AL: "Superconducting switch made of grapheneâ nanoribbon junctions" NANOTECHNOLOGY, IOP, BRISTOL, GB, vol. 19, no. 35, 3 September 2008 (2008-09-03), page 355706, XP020144541 ISSN: 0957-4484 | 1-4,7-9 | INV. H01L29/12 H01L29/16 H01L29/76 H01L29/06 H01L29/78 |
| Y | * page 1 - page 2; figures 1a-d * | 5-6 | |
| X | DRESSELHAUS M ET AL: "Other one-dimensional systems and thermal properties" JOURNAL OF VACUUM SCIENCE AND TECHNOLOGY: PART B, AVS / AIP, MELVILLE, NEW YORK, NY, US, vol. 26, no. 4, 13 August 2008 (2008-08-13), pages 1613-1618, XP012114338 ISSN: 1071-1023 * I. Introduction; III. Graphene Ribbons; figures 1, 2 * | 1-4,7-9 | |
| | | | **TECHNICAL FIELDS SEARCHED (IPC)** |
| | | | H01L |
| Y | R.M.WESTERVELD: "Graphene Nanoelectronics" SCIENCE, vol. 320, 18 April 2008 (2008-04-18), pages 324-325, XP002537577 * the whole document * | 5-6 | |
| A | WO 2007/097938 A1 (LUCENT TECHNOLOGIES INC [US]; PFEIFFER LOREN NEIL [US]) 30 August 2007 (2007-08-30) * abstract; claims 1-10; figures 1-6 * | 1-13 | |

-/--

The present search report has been drawn up for all claims

| Place of search | Date of completion of the search | Examiner |
|---|---|---|
| Munich | 20 July 2009 | Dauw, Xavier |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

&  : member of the same patent family, corresponding
document

EPO FORM 1503 03.82 (P04C01)

**Europäisches Patentamt**
**European Patent Office**
**Office européen des brevets**

# EUROPEAN SEARCH REPORT

Application Number

EP 09 15 3539

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | P. AVOURIS ET AL: "Carbon-based electronics"<br>NATURE NANOTECHNOLOGY NATURE PUBLISHING GROUP UK,<br>vol. 2, 1 October 2007 (2007-10-01), pages 605-615, XP002537578<br>* pages 605-606; figures 1, 6 *<br>* pages 611, 612 * | 1-13 | |
| A | OOSTINGA J B ET AL: "Gate-induced insulating state in bilayer graphene devices"<br>NATURE MATERIALS NATURE PUBLISHING GROUP UK,<br>vol. 7, no. 2, February 2008 (2008-02), pages 151-157, XP002537579<br>ISSN: 1476-1122<br>* pages 1,2 * | 1-13 | |
| A | M. FREITAG: "Graphene: Nanoelectronics goes flat out"<br>NATURE NANOTECHNOLOGY NATURE PUBLISHING GROUP UK,<br>vol. 3, 1 August 2008 (2008-08-01), pages 455-457, XP002537580<br>* the whole document * | 1-13 | TECHNICAL FIELDS SEARCHED (IPC) |
| A | MORADIAN R ET AL: "Investigation of electronic transport through graphene nanoribbon quantum dots"<br>PHYSICA E - LOW-DIMENSIONAL SYSTEMS AND NANOSTRUCTURES, ELSEVIER SCIENCE BV, NL,<br>vol. 41, no. 5,<br>4 January 2009 (2009-01-04), pages 801-805, XP025972368<br>ISSN: 1386-9477<br>[retrieved on 2009-01-04]<br>* abstract; figure 2 * | 1-13 | |

The present search report has been drawn up for all claims

| Place of search | Date of completion of the search | Examiner |
|---|---|---|
| Munich | 20 July 2009 | Dauw, Xavier |

EPO FORM 1503 03.82 (P04C01)

## ANNEX TO THE EUROPEAN SEARCH REPORT
## ON EUROPEAN PATENT APPLICATION NO.

EP 09 15 3539

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2009

| Patent document cited in search report | | Publication date | Patent family member(s) | | Publication date |
|---|---|---|---|---|---|
| WO 2007097938 | A1 | 30-08-2007 | CN 101385126 A | | 11-03-2009 |
| | | | EP 1984941 A1 | | 29-10-2008 |
| | | | KR 20080100430 A | | 18-11-2008 |
| | | | US 2007187694 A1 | | 16-08-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

•   US 20040253820 A

**Non-patent literature cited in the description**

•   **A. Susanto et al.** Ab initio study for structure, electric properties and light emission of linear-trans-quinacridone. *The European Physical Journal D,* 2006, vol. 38 (1), 199-201
•   **W. M. Heckl.** Molecular Self-Assembly and Nanomanipulation - Two Key Technologies in Nanoscience and Templation. *Advanced Engineering Materials,* 2004, vol. 6 (10), 843-847
•   **J. C. Mayer et al.** The maximum energy that can be transformed from an 80 keV electron to a carbon atom is 15.6 eV, which is below the threshold for knock-on damage but sufficient to form multiple SW defects. *Nano Letters*